(19) Europäisches Patentamt
European Patent Office
Office européen des brevets

(11) EP 4 746 666 A1

# (12) EUROPEAN PATENT APPLICATION

(43) Date of publication:
**20.05.2026 Bulletin 2026/21**

(21) Application number: **24213309.8**

(22) Date of filing: **15.11.2024**

(51) International Patent Classification (IPC):
***H10N 60/20*** *(2023.01)* ***H01F 6/06*** *(2006.01)*
*G21B 1/05* *(2006.01)*

(52) Cooperative Patent Classification (CPC):
**H10N 60/203; H01F 6/06;** G21B 1/055

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Proxima Fusion GmbH**
**81369 München (DE)**

(72) Inventors:
- **SLADE, Robert**
  **Aston, Bampton, OX18 2BF (GB)**
- **VAN NUGTEREN, Jeroen**
  **6021RW Budel (NL)**

(74) Representative: **Bardehle Pagenberg Partnerschaft mbB**
**Patentanwälte Rechtsanwälte**
**Prinzregentenplatz 7**
**81675 München (DE)**

## (54) SUPERCONDUCTOR CABLE FOR A SUPERCONDUCTOR CABLE ASSEMBLY AND RELATED SYSTEM AND METHOD

(57) A superconductor cable 21 for a superconductor cable assembly 22, comprising:
a superconductor region 19, the superconductor region 19 comprising:
high temperature superconductor material, optionally high temperature superconductor tapes 23, and
a first metallic stabilizer material 24;
a layer of ohmic heating material 25 at least partially surrounding the superconductor region 19;

wherein the layer of ohmic heating material 25 has a surface resistivity between $10^{-7}$ Ohm·m$^2$ and 1 Ohm·m$^2$.

23
21
24
60
60
25
26
$I_0$
60
50
60
$I_1$
RD
LD

Fig. 3c

EP 4 746 666 A1

## Description

TECHNICAL FIELD

This disclosure generally relates to a superconductor cable for a superconductor cable assembly and related systems and methods.

BACKGROUND

Superconductor cables have broad applications. As a notable application, stellarators are developed for magnetic confinement of plasmas to provide energy based on fusion reactions which occur inside the confined plasma of the stellarator. Inside the stellarator, the plasma is confined in a plasma vessel having a vacuum chamber, comprising a breeding blanket for providing the necessary fuel for the fusion reaction. To provide the magnetic confinement in the plasma vessel, stellarators require strong magnetic field coils. Using a superconductor material to carry the current inside the magnetic field coils allows a positive energy balance of the stellarator as the current in the cable has no electrical resistance, thereby avoiding ohmic losses of the cable during operation. Further, the use of superconductor material allows strong magnetic fields which improves the power density of the plasma and thus the power balance of a stellarator.

In superconductor cables, for example in magnetic field coils of stellarators, an unintended transition in the superconducting cable from a superconducting state to non-superconducting state is a risk factor. This transition is sometimes referred to as a "quench". A quench is the generic term used to describe the behavior of a superconducting magnet when part or all of the superconductor becomes non-superconducting. A quench poses a risk to superconductor cables.

Thus, a need exists to avoid or mitigate quenches in superconducting cables, in particular used in magnetic field coils of stellarators.

SUMMARY

The above desire is met at least in part by the embodiments outlined herein.

In a first embodiment, a superconductor cable for a superconductor cable assembly comprises:
a superconductor region, the superconductor region comprising:

high temperature superconductor material, and

a first metallic stabilizer material.

The superconductor cable may further comprise:
a layer of ohmic heating material at least partially surrounding the superconductor region.

The layer of ohmic heating material may have a surface resistivity between $10^{-7}$ Ohm·m$^2$ and 1 Ohm·m$^2$.

In one embodiment, a superconductor cable for a superconductor cable assembly, comprises:
a superconductor region, the superconductor region comprising:

high temperature superconductor material, optionally high temperature superconductor tapes and

a first metallic stabilizer material; the superconductor cable further comprising:
a layer of ohmic heating material at least partially surrounding the superconductor region.

In some embodiments, the layer of ohmic heating material has a surface resistivity between $10^{-7}$ Ohm·m$^2$ and 1 Ohm·m$^2$, optionally between $10^{-6}$ Ohm·m$^2$ and $10^{-1}$ Ohm·m$^2$, optionally between $10^{-5}$ Ohm·m$^2$ and $10^{-2}$ Ohm·m$^2$, optionally between $10^{-4}$ Ohm·m$^2$ and $10^{-3}$ Ohm·m$^2$, optionally between $2 \cdot 10^{-4}$ Ohm·m$^2$ and $5 \cdot 10^{-4}$ Ohm·m$^2$, optionally of approximately $3 \cdot 10^{-4}$ Ohm·m$^2$; and/or.

In some embodiments, the layer of ohmic heating material may has a surface resistivity between $10^{-7}$Ohm·m$^2$ and $3 \cdot 10^{-4}$ Ohm ·m$^2$, optionally between $5 \cdot 10^{-7}$ Ohm·m$^2$ and $1.5 \cdot 10^{-4}$ Ohm·m$^2$, optionally between $1 \cdot 10^{-6}$ Ohm·m$^2$ and $7.5 \cdot 10^{-5}$ Ohm·m$^2$, optionally between $5 \cdot 10^{-6}$ Ohm·m$^2$ and $3 \cdot 10^{-5}$ Ohm·m$^2$, optionally between $10^{-5}$ Ohm·m$^2$ and $1.5 \cdot 10^{-5}$ Ohm·m$^2$, optionally between $3 \cdot 10^{-5}$ Ohm·m$^2$ and $1 \cdot 10^{-5}$ Ohm·m$^2$

In some embodiments, the layer of ohmic heating material may has a surface resistivity between $3 \cdot 10^{-4}$ Ohm·m$^2$ and 1 Ohm·m$^2$, optionally between $1 \cdot 10^{-3}$ Ohm·m$^2$ and $3 \cdot 10^{-1}$ Ohm·m$^2$, optionally between $3 \cdot 10^{-3}$ Ohm·m$^2$ and $1 \cdot 10^{-1}$ Ohm·m$^2$, optionally between $1 \cdot 10^{-2}$ Ohm·m$^2$ and $3 \cdot 10^{-2}$ Ohm·m$^2$, optionally between $3 \cdot 10^{-2}$ Ohm·m$^2$ and $1 \cdot 10^{-1}$ Ohm·m$^2$, optionally between $1 \cdot 10^{-1}$ Ohm·m$^2$ and $3 \cdot 10^{-1}$ Ohm·m$^2$.

However, other ranges are possible as well as will be explained herein. In particular, ranges which fulfill the conditions described below may be chosen.

The surface resistivity may be given by $v = \rho \cdot t$, where $\rho$ is the bulk resistivity and t is the thickness of a material, for example the layer of ohmic heating material.

The surface resistivity and/or the bulk resistivity may be determined by methods as known in the art, and as detailed herein.

The high temperature superconductor material may be or comprise high temperature superconductor tapes. For example, the stack of high temperature superconductor tapes may comprise tapes based on Rare Earth Barium Copper Oxide superconductor, ReBCO.

The layer of ohmic heating material may contribute to a faster propagation of a non-superconducting zone during a quench. The layer of ohmic heating material may influence a direction of propagation of the non-superconducting zone into a desired direction during a quench. Therefore, the heating due to the layer of ohmic heating material may cause the non-superconducting zone to grow in a manner determined by the design of the superconducting cable. Thus, the superconductor cable may have improved properties during a quench. The layer of ohmic heating material may contribute to a propagation along a length of the superconductor cable, raising the temperature of the superconducting cable with improved uniformity, thereby mitigating detrimental effects of the quench, for example localized heating that may occur during the quench which may cause material defects due to overheating if not mitigated. The ohmic heating material may homogenize the way the heat generated by the current carried in the superconductor cable is dissipated by ohmic heating during a quench.

The superconductor cable may comprise: a layer of second metallic stabilizer material.

The layer of ohmic heating material may be arranged at least partially or entirely between the superconductor region and the layer of second metallic stabilizer material.

The surface resistivity of the ohmic heating material may be defined between the superconductor region and the layer of second metallic stabilizer material.

The layer of second metallic stabilizer material may contribute to a current from the superconductor region bypassing a non-superconducting region of the high temperature superconductor material if such a region develops. As will be detailed below, the layer of second metallic stabilizer may contribute to targeted heating of the superconductor region and may lead to an improved quench behavior. This will be detailed elsewhere. The layer of second metallic stabilizer material may also provide a heat capacity to at least partially absorb the heat generated by the current in the non-superconducting region. In some embodiments, the amount of the layer of second metallic stabilizer material may be a trade-off between space requirements of the layer and second metallic stabilizer and the beneficial properties described above.

As the layer of ohmic heating material may be arranged at least partially or entirely between the superconductor region and the layer of second metallic stabilizer material, a current originating from the superconductor region, for example from the high temperature superconductor material for example after a transition from a superconducting to a non-superconducting state, may have to at least partially pass through the layer of ohmic heating material before reaching the second metallic stabilizer material. Further, the current may transition back to the high temperature superconductor material at a different location, for example a location in which the high temperature superconductor material is still in a superconducting state, the current may have to pass once more through the layer of ohmic heating material. Thus, the layer of second metallic stabilizer material may contribute to the ohmic heating and/or contribute to a desired location of the ohmic heating, for example in the layer of ohmic heating material and/or contribute to ohmic heating itself and/or increase the current carrying capacity of the superconductor cable. The layer of second metallic stabilizer material may contribute to targeted heating which may lead to enhanced quench behavior.

The layer of ohmic heating material may entirely surround the superconductor region. In some embodiments, the layer of ohmic heating material is arranged in between the superconductor region and the second metallic stabilizer material.

Entirely surrounding the superconductor region may have the advantage that any current leaving the high temperature superconductor material, for example during a quench, must pass through the layer of ohmic heating material, thereby contributing to localized ohmic heating. In other embodiments a similar effect may be achieved, for example by using insulating layers which limit the possible ways the current can take and/or to determine possible ways through which the current must pass, so that the current must pass through the layer of ohmic heating material.

Arranging the layer of ohmic heating material in between the superconductor region and the second metallic stabilizer material may have the advantage, that significant amount of current pass through the ohmic heating material, for example if there is no other electrical path with a lower resistance available to bypass a developing non-superconducting region in the high temperature superconductor material. In some embodiments, the path of current may be further controlled by additional insulation, for example layers of insulation, as will be explained below.

In some embodiments, the layer of ohmic heating material has a thickness between 0.01 mm to 10 mm. This may have the effect that the layer ohmic heating material has a resistance which allows significant heating while the thickness at the same time may allow for a resistance low enough that sufficient current passes through the layer of ohmic heating material.

In some embodiments, the superconductor cable has the following property: when from a first position along the superconductor cable to a second position along the superconductor cable the high temperature superconductor material is in a non-superconducting state, the superconductor cable has:

a first resistance, Rnz, determined for current passing through the superconductor region from the first position to the second position and

a second resistance, Rbypass, determined for current not passing through the superconductor region from the first position to the second position;

A ratio Rnz to Rbypass may be at least 1. The ratio Rnz to Rbypass may be larger than 0.8, preferably 1.0, preferably larger than 1.0, preferably 1.5, preferably 2, preferably larger than 2, preferably 4, preferably larger than 4, preferably 5, preferably larger than 5, preferably larger than 8, preferably 8, preferably larger than 10, preferably 10, preferably larger than 20. In some embodiments, said ratio is below 50, in some embodiments below 30, in some embodiments below 25.

As the ratio increases, the ratio of heat deposited in the ohmic heating layer compared to the heat deposited into the remaining volume of the cable may be increased. This may improve the quench behavior of the cable.

The ratio Rnz to Rbypass may have the above ratio value, for example at least 1, if a distance between the first position and the second position is at least 5 mm.

In some embodiments, the resistance Rnz denotes the finite resistance by the superconducting region in a non-superconducting state (sometimes referred to as "normal zone", nz). In some embodiments, Rbypass denotes the resistance for a current bypassing the normal zone.

Such a ratio may have the advantage that a quench may be mitigated in a beneficial manner, for example the non-superconducting region may propagate quickly along a length of the superconductor cable and thus at a higher speed than the heat diffusion to the side of the cable and/or into adjacent cables.

In some embodiments, the superconductor cable further comprises:

a layer of insulation material at least partially surrounding the layer of second metallic stabilizer material. The layer of insulation material may have a resistivity of at least $1 \cdot 10^4$ Ohm · m, preferably of at least $1 \cdot 10^5$ Ohm · m, preferably of at least $1 \cdot 10^{10}$ Ohm · m, preferably of at least $1 \cdot 10^{13}$ Ohm · m, preferably of at least $1 \cdot 10^{16}$ Ohm · m. In some embodiments, the layer of insulation material may have a resistivity of $1 \cdot 10^{17}$ Ohm · m or below, in some embodiments of $2 \cdot 10^{16}$ Ohm · m or below.

The layer of insulation material may control a path of the current during a quench. In some embodiments, the layer of insulation material may be placed within the second metallic stabilizer material, for example at least partially separating the layer of second metallic stabilizer material into a first part and a second part. This separation may have the effect that one part can no longer act as an electrical stabilizer to allow the current to bypass. However, such a part may still act as a mechanical stabilizer. For example, the first part may be in electrical contact to the superconductor region and act as both an electrical and a mechanical stabilizer. The second part may be insulated and may act as a mechanical stabilizer only.

The first part and the second part may have different material properties. For example, the first part may be copper, the second part may be a solid material, for example steel, for example a structural steel alloy.

It is notable, that the presence or absence of insulation material may allow different embodiments. In embodiments without or with partial insulation, for example layers of insulation material, adjacent structures, for example adjacent superconducting cables of similar, identical or different embodiments may act with functions comparable to the second metallic stabilizer material. In other embodiments in which insulation material is present, the flow of current during a quench may be more constrained. Thus, different optimization of the material may be enabled.

In some examples, there is no insulation between adjacent structures, for example adjacent superconducting cables. In such examples, in case of a quench of a single cable, the current of that cable may use remaining current carrying capacity of an adjacent superconducting cable. In some embodiments, adjacent structures may benefit the quench behavior.

In some examples, adjacent structures, for example adjacent superconducting cables may be fully insulated from each other. In such cases, each current is confined to each individual structure, for example each cable. The latter option may allow greater control in case of a quench and/or may reduce forces occurring during a quench.

Also, combinations of the two approaches are possible, for example with insulation in a first direction and without insulation in a second direction.

In some embodiments, a plurality of layers of insulation materials may be present.

In some embodiments, the layer of insulation material may have a resistivity of below $10^{16}$ Ohm · m, in some embodiments below $10^{13}$ Ohm · m, in some embodiments below $10^9$ Ohm · m, in some embodiments below $10^8$ Ohm · m.

In some embodiments, an insulator has a resistivity exceeding the resistivity of the ohmic heating layer and/or exceeding the resistivity of a metallic stabilizer material, for example the first and/or the second metallic stabilizer material.

In some embodiments, the superconductor cable, optionally the superconductor region, further comprises:

at least one second high temperature superconductor material, optionally at least one second stack of high temperature superconductor tapes and/or

at least one third high temperature superconductor material, optionally at least one third stack of high temperature superconductor tapes and/or

at least one fourth high temperature superconductor material, optionally at least one fourth stack of high temperature superconductor tapes.

Additional high temperature superconductor materials may be present, for example a plurality of high temperature superconductor materials.

In some embodiments, the high temperature superconductor material, the at least one second high temperature superconductor material, the at least one third high temperature superconductor material and/or the at least one fourth high temperature superconductor material are one or more of the following:

electrically insulated from each other,

electrically connected with each other,

connected by a third metallic stabilizer material,

at least partially or entirely surrounded by the layer of ohmic heating material.

This may provide additional degrees of freedom for optimizing the behavior of the superconductor cable during a quench.

In some embodiments, the high temperature superconductor material and/or the at least one second high temperature superconductor material and/or the at least one third high temperature superconductor material and/or the at least one fourth high temperature superconductor material is twisted along a length of the superconductor cable.

In some embodiments, the stack of high temperature superconductor tapes and/or the at least one second stack of high temperature superconductor tapes and/or the at least on third stack of high temperature superconductor tapes and/or the at least on fourth stack of high temperature superconductor tapes is twisted along the superconductor cable.

Twisting may increase the ability of the superconductor cable to bend and still maintain advantageous properties. In some embodiments, twisting allows the cable to preserve material properties for smaller bending radii than compared to cables without twisting, for example for stacks of high temperature superconductor tapes but also for other materials or other type of superconductor materials.

In some embodiments, the first metallic stabilizer material further comprises a metallic jacket layer.

The metallic jacket layer may contribute to the electrical conductivity of the first metallic stabilizer material. The metallic jacket layer may provide mechanical stability and/or oxidation resistance.

In some embodiments, along a length of the superconductor cable:

the resistivity of the ohmic heating material changes and/or

a local thickness of the ohmic heating material changes.

A local thickness may be the diameter of the ohmic heating material at a given local position, for example a position along a length of the superconductor cable. In other examples, a local thickness may be an average thickness in a cross-section of the superconductor cable at a position, for example a position along the length of the superconductor cable.

By modifying the resistivity and/or the local thickness of the ohmic heating material, the local heating and/or the behavior of the superconductor cable in case of a quench may be optimized. Modifying resistivity and/or the local thickness may allow a non-uniform propagation velocity of a non-superconducting region. It may be advantageous is the velocity is higher in regions far away from the beginning and/or end of a superconductor cable while at the beginning and/or end a lower velocity may be acceptable.

In some embodiments, the local thickness and/or resistivity of the ohmic heating material in a region at the start along the length of the superconductor cable and in a region at the end along the length of the superconductor cable may be different from the local thickness and/or resistivity of the ohmic heating material in a region in the middle along the length of the superconductor cable.

This may allow for faster propagation of a non-superconducting zone in some regions compared to other regions and contribute to mitigating a quench that may develop at various regions.

In some embodiments, the first metallic stabilizer material comprises at least one of the following materials: solder, copper, copper alloy, brass, aluminium, aluminium alloy.

Choosing the first metallic stabilizer material from this list may provide good mechanical stability and/or good electrical conductivity between the first metallic stabilizer material and the stack of high temperature superconductor tapes. In case of a quench choosing the first metallic stabilizer material accordingly may allow the current to, at least partially, pass through the first metallic stabilizer material in the region in which the stack of high temperature superconductor tape is no longer superconducting.

In some embodiments, the layer of ohmic heating material comprises at least one of the following materials: silicon carbide, semi-metals, semiconductors, anodised aluminium, matrix composites.

Matrix composites may comprise a conductive material in an insulating matrix material. The conductive material may be for example in particles, fibre, and/or mesh form. The conductive material may be one of the conductive materials mentioned above, for example a metal. The insulating matrix may be carbon, for example graphite and/or epoxy. In addition, or alternatively, the insulating matrix may comprise plastic, hydrocarbon oil, wax, and/or grease.

Insulating matrix materials may be in a solid phase at cryogenic temperatures relevant for superconductivity of the superconducting cable during operation, but in a liquid or gel-like phase at room temperature. This may ease manufacturing steps with the superconductor cables, for example winding of the cables, for example during manufacturing of magnetic field coils. Epoxy may be selected with a long cure time and/or epoxy which require heat for curing may be selected, thereby also simplifying the manufacturing process. In some examples, the material in a liquid and/or gel-like phase may be held in place using a holding material, for example a glass fibre material. The holding material may be wrapped, for example strip-wrapped around the stack of high temperature superconductor tapes embedded in a first metallic stabilizer material. In some embodiments, the selected materials, for example matrix composites may have a coefficient of thermal expansion matching the coefficient of thermal expansion of the stack of high temperature superconductor tapes and/or the first metallic stabilizer material. In other embodiments, all expansions coefficients of the layers in the superconductor cable are selected to match.

In some embodiments, the layer of second metallic stabilizer material comprises at least one of the following materials: a high-conductive material, solder, copper, copper alloy, brass, aluminium or aluminium alloy, a high-strength material, steel.

Use of such materials or combinations of such materials in the second metallic stabilizer material may minimize the resistivity of the second metallic stabilizer material. A reduced resistivity of the second metallic stabilizer material may increase the heat deposited by ohmic heating in a localized manner by the layer of ohmic heating material. Using of high-strength material may provide mechanical stability. Also, a mixture, for example fiber composites, is possible.

In some embodiments, the optional layer of insulation material comprises at least one of the following materials: organic insulators, polyimide, inorganic insulators, ceramic, non-conductive epoxy, a glass fibre matrix, insulation paper, insulating lacquer, paint

The optional layer of insulation material may be used to guide the current during a quench into a desired direction. The above mentioned materials, for example in film and/or tape form may be used. In some embodiments, non-conductive epoxy is used alternatively or in addition. In some examples, stycast in a glass fibre matrix is used. In other embodiments, insulation paper, insulating lacquer and/or paint is used. Also, combinations of the insulation material can be used.

In some embodiments, the metallic jacket layer comprises at least one of the following materials: a high-conductive material, solder, copper, copper alloy, brass, aluminium or aluminium alloy, a high-strength material, steel.

In some embodiments, a superconductor cable assembly is provided, preferably a superconductor magnetic field coil. The superconduct cable assembly may comprise a plurality of turns of a superconductor cable and/or a plurality of superconductor cables according to the previous or following embodiments.

This may allow to provide a cable assembly and/or a superconductor magnetic field coil which provides improved performance in case of a quench.

A second embodiment provides a superconductor cable assembly comprising at least one superconductor cable. The at least one superconductor cable comprising:

a superconductor region, the superconductor region comprising:

> high temperature superconductor material, optionally high temperature superconductor tapes and
>
> a first metallic stabilizer material.

The superconductor cable may further comprise: a layer of ohmic heating material. The layer of ohmic heating material may at least partially surround the superconductor region. The superconductor cable assembly may further comprise:

a layer of second metallic stabilizer material. The layer of second metallic stabilizer material may at least partially or entirely surround the layer of ohmic heating material.

In some embodiments, a thickness and resistivity of the layer of ohmic heating material are configured such that a first velocity, v1, of a non-superconducting zone propagation along the superconductor cable is larger than a second velocity, v2, of non-superconducting zone propagation in a radial direction of the superconductor cable assembly.

Such a superconductor cable assembly may have advantageous properties in case of a quench. In particular, the non-superconducting zone propagation along the cable may dissipate the current carried in the stack of high temperature superconductor tapes more evenly in the volume of the at least one superconductor cable, thereby mitigating the effects of a quench and preventing or at least reducing potential damage to the superconductor cable assembly.

The first velocity may be at least in part be influenced by the heat generated by current passing through the ohmic heating material. In such examples, the first velocity may be significantly enhanced compared to the second velocity. The second velocity may be determined in part or entirely by thermal diffusion of heat from the non-superconducting zone.

The first velocity may be significantly faster than the second velocity, for example by a factor of 2, for example by a factor of 5, for example by at least one order or magnitude, for example by a factor of at least 25, for example by a factor of at least 50, for example by a factor of at least 75, for example by at least two orders of magnitude.

In some embodiments, the first velocity may be faster than the second velocity by at most three orders of magnitude.

The superconductor cable assembly may be a magnetic field coil comprising a plurality of turns of the at least one superconductor cable. The radial direction of the superconductor cable assembly may be a radial direction of the magnetic field coil. The radial direction of the superconductor cable assembly may be a direction perpendicular to a local direction along at least one of the plurality of turns.

The radial direction may be a direction orthogonal to the direction the cable travels locally at any point in the coil for at least a region of the coil.

Such a superconductor cable assembly may allow to provide a magnetic field coil with improved quench properties, for example for a stellarator.

In some embodiments, a ratio of the first velocity to the second velocity is configured such that a locally formed non-superconducting zone in one of the turns of the plurality of turns propagates along a substantial distance of the turn before an adjacent turn becomes non-superconducting.

A substantial distance may be at least 1% of the turn, for example at least 5% of the turn, for example at least 10% of the turn, for example at least 25% of the turn, for example at least 40% of the turn, for example at least 50% of the turn, for example at least 75% of the turn, for example the entire turn.

In some examples, a substantial distance may be less than 150% of a turn, for example less than 101% of the turn. In other examples, the substantial distance may be even less, for example less than an entire turn, for example less than 80% of the turn, for example less than 60% of the turn, for example less than 30% of the turn.

This may further improve the advantageous properties of the superconductor cable assembly in case of a quench. For example, the current may contribute to a more uniform heating of the at least one cable of the superconductor cable assembly.

In some embodiments, the superconductor cable assembly further comprises a layer of insulation material surrounding the layer of second metallic stabilizer material, wherein the layer of insulation material has a resistivity of at least $1 \cdot 10^4$ Ohm · m, preferably of at least $1 \cdot 10^7$ Ohm · m.

The layer of insulation material may have the numerical values described above.

In some embodiments, the second metallic stabilizer further comprises a conductive support structure, wherein the superconductor cable is at least partially embedded in or at least partially surrounded by the conductive support structure.

Partially or entirely embedding and/or surrounding may have the advantage that the conductive support structure may provide mechanical support of the superconductor cable assembly. In some examples, the conductive support structure may allow a significant amount of current to pass through the conductive support structure. In such examples, the conductive support structure may contribute to mitigating a quench in the superconductor cable assembly. In some examples, the second metallic stabilizer is entirely made of the conductive support structure. In those examples, but also in examples in which the second metallic stabilizer is a combination of second metallic stabilizer material and a conductive support structure, the required amount of material to manufacture the at least one superconductor cable may be reduced.

In some embodiments, the conductive support structure comprises at least one of the following materials: stainless steel, titanium, composite carbon fibre, inconel, nitronic alloy, high strength alloys. Stainless steel may be stainless steel alloys suitable for a cryogenic environment.

Using such materials may provide a beneficial trade-off of mechanical stability and electrical conductivity of the conductive support structure.

In some embodiments, the superconductor cable assembly is a planar magnetic field coil or a non-planar magnetic field coil for a stellarator.

This may allow to provide improved magnetic field coils for a stellarator.

In a further embodiment, a system for preventing damage to at least one superconductor cable assembly according to the previous embodiments is provided. The system may comprise at least one sensor connected to the at least one superconductor cable assembly. The system may comprise a power control unit connected to the at least one superconductor cable assembly. The system may comprise at least one non-superconducting zone generation means connected to the at least one superconductor cable assembly. The system may further comprise a dump circuitry.

The system may comprise a control unit, operably connected to the at least one sensor, the power control unit, optionally connected to the at least one non-superconducting zone generation means and optionally connected to the dump circuitry. The control unit may be configured to:

determine that a local non-superconducting zone has developed in at least one of the at least one superconductor cable assembly based on the at least one sensor;

The control unit may be configured to interrupt a connection to a power control unit of the at least one superconductor cable assembly;

This may allow mitigating a quench in an improved manner.

The control unit may be configured to connect a dump circuitry to at least one superconductor cable assembly, for example a superconductor magnetic field coil. The dump circuitry may comprise an external dump resistor and/or dump varistor. In addition or alternatively, the dump circuitry may comprise a diode, for example a high current diode, for example at least one pair of diodes. In addition or alternatively, the dump circuitry may comprise a switch. However, other arrangements are possible. The dump circuitry may connect parts of the superconducting cable assembly, for example if activated. For example, the dump circuitry may connect ends of the turns of the superconductor cable. The dump circuitry may be designed to be able to carry the entire current of the cable assembly. In some embodiments, the dump circuitry may be designed to be able to carry the current of at least one superconductor cable. In some embodiments, the dump circuitry may be designed to be able to carry the current of at least one turn.

Using a dump circuitry may be advantageous in cases where the superconductor cable assembly comprise insulation, for example in cases in which the superconductor cable comprise layers of insulation material. This may allow the current to at least partially dissipate through the dump circuit.

In some embodiments, for example if the superconductor cable or the cable assembly does not comprise layer of insulation material, it may not be required to connect any kind of dump circuit. In some examples, the current of the superconductor cable may be dissipated by the cable according to embodiments during the quench in a favorable manner.

In other embodiments, for example in embodiments in which the cable assembly or the superconductor cable comprises a layer of insulation material, it may be required to provide a connection between parts of the superconductor cable assembly, for example the turns during a quench.

The control unit may be configured to activate the non-superconducting zone generation means to generate at least one additional non-superconducting zone in the at least one superconductor cable assembly.

In some embodiments, the non-superconducting zone generation means is at least one of the following:

at least one heating element attached to the at least one superconductor cable assembly

at least one alternating current generation means coupled to the at least one superconductor cable assembly.

In some embodiments, the superconductor cable has at least one region of low critical current. Then, this region may be quenched by briefly increasing a current in the superconductor cable above the low critical current value. This may have the advantage that by design the region, in which the quench starts to occur is predetermined.

In some embodiments, the non-superconducting zone generation means may be a controller configured to briefly raise the current carried in the cable assembly, for example above a threshold value, for example above the low critical current of the cable.

In some embodiments, the non-superconducting zone generation means may comprise removing at least part of the cooling from at least a part of the at least one superconductor cable assembly.

In some embodiments, the non-superconducting zone generation means may comprise energizing an electromagnet in proximity to the at least one superconductor cable assembly.

The electromagnet may cause a local rotation of the net magnetic field vector inside the superconductor material. In some superconductor materials, for example in some high temperature superconductor tapes, for example in ReBCO tapes, the critical current may be very sensitive to the net magnetic field vector, thereby allowing triggering of a quench by the non-superconducting zone generation means.

The control unit may be further configured to: activate the at least one heating element and/or the at least one alternating current generation means to generate the at least one additional non-superconducting zone.

The non-superconducting zone generation means may improve the quench behavior of the system and/or the superconductor cable assembly.

In a further embodiment, a method for preventing damage to at least one superconductor cable assembly is provided. The method comprises:

determining that a local non-superconducting zone has developed in the at least one superconductor cable assembly;

interrupting a connection of a power control unit with the superconductor magnetic field coil;

The method may further comprise: activating a non-superconducting zone generation means to generate at least one additional non-superconducting zone;

The method may further comprise: connecting a dump circuitry to the at least one superconductor cable assembly.

The method may improve the quench behavior of the at least one superconductor cable assembly. In some embodiments, the method may allow for a controlled shutdown of a superconductor cable assembly adjacent to a superconductor cable assembly undergoing a quench. The thermal heat produced by the quench of a first superconductor cable assembly may be so large that an adjacent superconductor cable assembly, for example an adjacent magnetic field coil, will also undergo a quench if the method is not applied. However, by applying the method the adjacent magnetic field coil may be shut down in a controlled manner.

The non-superconducting zone generation means may be at least one of the following:

at least one heating element attached to the at least one superconductor cable assembly,

at least one alternating current generation means coupled to the at least one superconductor cable assembly.

The at least one superconductor cable assembly may comprise a plurality of superconductor cable assemblies. The method may further comprise:
in response to the determining that a local non-superconducting zone has developed in the at least one superconductor cable assembly: performing at least one of the steps of interrupting, activating and connecting for at least one, at least several, or all of the plurality of superconductor cable assemblies.

Each of the at least one superconductor cable assembly may be a superconductor magnetic field coil.

Determining that a local non-superconducting zone has developed in the at least one superconductor cable may comprise determining that a local non-superconducting zone has developed in at least one of the turns of at least one of the at least one superconductor magnetic field coil.

The at least one heating element and/or the at least one alternating current generation means may be attached to one or more turns of the plurality of turns.

In another embodiment, a stellarator is provided. The stellarator comprises at least one of the superconductor cables according to one or more of the previous embodiments.

In another embodiment, a stellarator is provided. The stellarator comprises a superconductor cable assembly according to one or more of the previous embodiments.

## BRIEF DESCRIPTION OF THE DRAWINGS

One of more embodiments will now be described by way of example only with reference to the accompanying drawings in which:

Fig. 1 shows a schematic view of a stellarator according to an embodiment.

Fig. 2a and Fig. 2b show different views of a superconductor cable for a superconductor cable assembly according to an embodiment.

Fig. 3a and Fig. 3b show different views of a superconductor cable according to an embodiment, for example for a superconductor cable assembly.

Fig. 3c shows behavior during a quench of a superconductor cable according to an embodiment.

Fig. 4 shows a cross section of a superconductor cable according to an embodiment.

Fig. 5a, Fig. 5b, and Fig. 5c, and Fig. 5d shows cross sections of different superconductor cable according to various embodiments.

Fig. 6 shows a superconductor cable according to an embodiment.

Fig. 7a and Fig. 7b show a superconductor cable assembly according to an embodiment.

Fig. 7c and Fig. 7d show a superconductor cable assembly according to an embodiment.

Fig. 7e show a superconductor cable assembly according to an embodiment.

Fig. 8 shows an example of non-superconducting zone propagation according to an embodiment.

Fig. 9 shows a superconductor cable assembly configured as a non-planar magnetic field coil for a stellarator according to an embodiment.

Fig. 10 shows a cross-sectional view of a superconductor cable assembly which is a superconductor magnetic field coil according to an embodiment.

Fig. 11a shows a sectional view of a superconductor cable assembly according to an embodiment.

Fig. 11b shows two sectional views of a superconductor cable assembly according to an embodiment.

Fig. 11c shows a diagram according to an embodiment.

Fig. 12 shows a system for preventing damage to at least one superconductor cable assembly according to an embodiment.

Fig. 13 shows a method for preventing damage to at least one superconductor cable assembly according to an embodiment.

## DETAILED DESCRIPTION

In the following, a detailed description with reference to the figures is provided. In the figures, identical reference signs refer to identical elements.

In the following figures, LD denotes the direction along a cable and RD denotes the radial direction, unless otherwise stated.

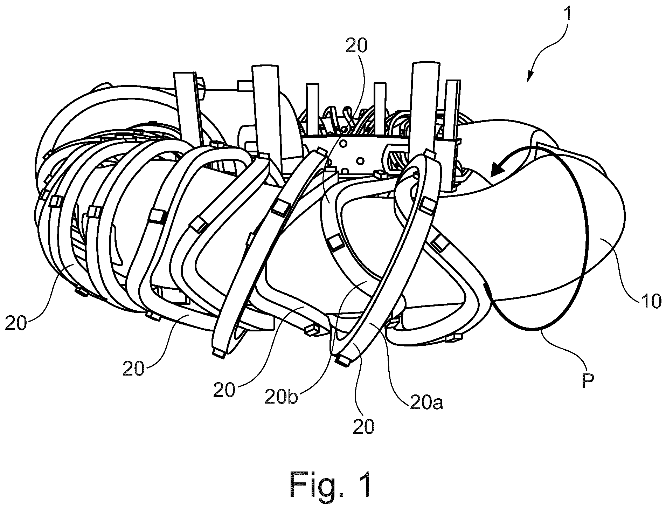

Fig. 1 shows a schematic view of a stellarator according to an embodiment. The stellarator 1 comprises a plasma vessel 10 and multiple superconductor cable assemblies, namely superconductor magnetic field coils 20. As shown in Fig. 1, some of the superconductor magnetic field coils 20 may be planar magnetic field coils, for example planar magnetic field coil 20a. Some of the superconductor magnetic field coils 20 may be non-planar magnetic field coils, for example non-planar magnetic field coil 20b. In some embodiments, a stellarator may only comprise non-planar magnetic field coils. In other embodiments, a stellarator may only comprise planar magnetic field coils. In yet other embodiments, a stellarator may both comprise planar and non-planar magnetic field coils, similar to the stellarator 1 shown in Fig. 1. The magnetic field coils may be predominantly arranged in a poloidal direction P as shown in Fig. 1.

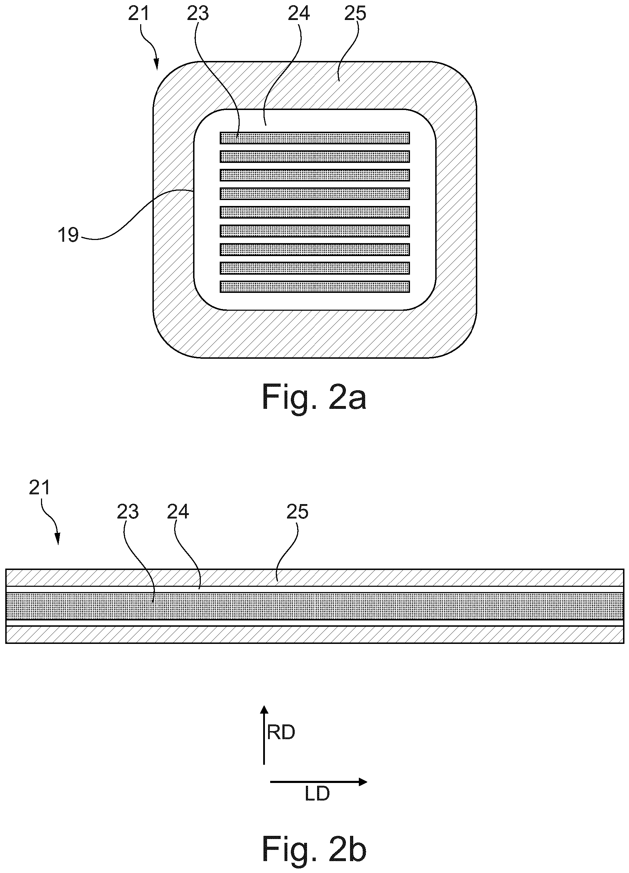

Fig. 2a and Fig. 2b show a superconductor cable 21 for a superconductor cable assembly according to an embodiment. Fig. 2a shows a cross-section of the superconductor cable 21 in a radial plane of the superconductor cable, Fig. 2b shows a cross section in a plane along the length of the superconductor cable LD and the radial direction RD.

The superconductor cable 21 comprises a superconductor region 19. As shown in Fig. 2a, the superconductor region 19 comprises high temperature superconductor material, in the example of Fig. 2a high temperature superconductor tapes 23 and a first metallic stabilizer material 24. In the following figures, the superconductor region 19 may not be shown in the drawings but may be defined in similar or identical way.

Other types of superconductor material may be used. The superconductor material, for example the stack of high temperature superconductor tapes 23, may be embedded in a first metallic stabilizer material 24. The superconductor cable 21 further comprises a layer of ohmic heating material 25 at least partially surrounding the stack of high temperature superconductor tapes 23 embedded in the first metallic stabilizer material 24. In the example of Fig. 2a and Fig. 2b, the layer of ohmic heating material 25 entirely surrounds the stack of high temperature superconductor tapes 23 embedded in the first metallic stabilizer material 24. However, in other embodiments the layer of ohmic heating material 25 may partially surround the superconductor region, for example the stack of high temperature superconductor tapes 23 and/or the first metallic stabilizer material 24 region, or be arranged in a different manner as described herein.

The layer of ohmic heating material 25 may have a resistivity that is higher than a resistivity of the first metallic stabilizer material 24.

The layer of ohmic heating material 25 may have a surface resistivity between $10^{-7}$ Ohm·m$^2$ and 1 Ohm·m$^2$,

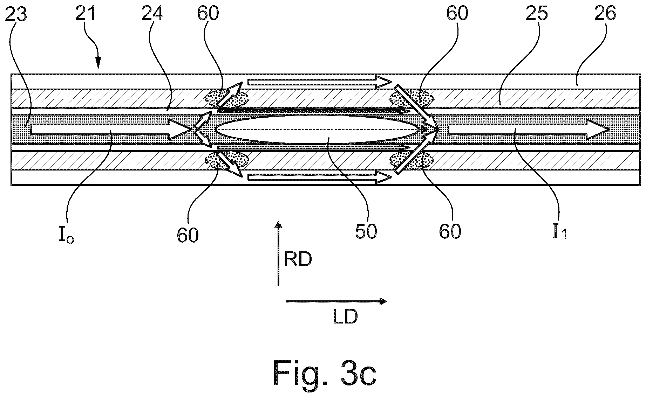

This specific range of surface resistivity allows for advantageous control of current flow and heat deposition in the superconductor cable 21 in case of a quench. This will be detailed with reference to Fig. 3c.

The surface resistivity, $\nu$, may be given by $v = \rho \cdot t$, where $\rho$ is the bulk resistivity and t is the thickness of a material, for example the layer of ohmic heating material.

The surface resistivity may be given by $v = \rho \cdot t$, where $\rho$ is the bulk resistivity and t is the thickness of a material, for example the layer of ohmic heating material.

In general, the surface resistivity and/or the bulk resistivity may be determined by methods as known in the art, for example using four-point probe method and Van der Pauw method, for example as described in

Wikipedia contributors, "Van der Pauw method," Wikipedia, The Free Encyclopedia, https://en.wikipedia.org/w/index.php?title=Van_der_Pauw_method&oldid=1236164 392 (accessed November 14, 2024).

In some embodiments, the methods described in references therein may be used.

In some embodiments, the material under test is put between two copper plates. The two copper plates may be a few mm thick, for example 1 mm, for example 2 mm, for example 5 mm. In some examples, the thickness may be chosen so that the resistivity of the copper plates is negligible compared to the material to be measured, for example the layer of ohmic heating material. Then, a current may be passed through the plates and the voltage drop across the plates may be measured, for example via four wire measurement. The value may then be determined using Ohm's law. The measurements may be conducted at room temperature. The measurements may be conducted for 1 minute, but also for shorter time periods, for example 30 seconds, for example 5 seconds, for example 1 second.

In some examples a method defined in Surface Resistivity, Volume Resistivity, ASTM D257, IEC 62631-3-1 may be used. Other standard methods are known in the art. In some embodiments, other standard methods may be used.

In some examples, the method described in Oliveira FS, Cipriano RB, da Silva FT, Romão EC, Dos Santos CAM, Simple analytical method for determining electrical resistivity and sheet resistance using the van der Pauw procedure, Sci Rep. 2020 Oct 2;10(1):16379. doi: 10.1038/s41598-020-72097-1. PMID: 33009433; PMCID: PMC7532437, may be used to determine the bulk resistivity and/or the surface resistivity.

One or more of the above measurements may be conducted at different temperatures. For example, the resistivity of the materials herein, for example the bulk and/or surface resistivity of the layer of ohmic heating material, may be measured and/or defined in the range between 1 K and 300 K, for example between 5 K and 300 K, for example between 12 K and 300 K, for example at 5 K, for example between 5 K and 20 K, for example between 5 K and 50 K, for example at around 77 K, for example at 77 K, for example between 5 K and 77 K, for example between 5 K and 77.36 K, for example at 77.36 K, for example at atmospheric pressure. In some embodiments, bulk and/or surface resistivity may be measured and defined at a given temperature, for example one of the temperatures, for example one of the limits of the intervals, mentioned above. In other embodiments, an average value averaged over at least one of the temperature intervals mentioned above may be used. The measurements may be conducted using a variable temperature cryostat insert.

The layer of ohmic heating material 25 may have a thickness between 0.01 mm to 10 mm, in some examples between 0.05 mm and 5 mm, in some examples between 1 mm and 2 mm.

In some embodiments, the thickness is chosen based on the bulk resistivity of the layer of ohmic heating material.

The superconductor cable 21 may be curved, for example it may constitute an arc of a superconductor cable assembly and/or a superconductor magnetic field coil 20, 20a, 20b as shown in Fig. 1.

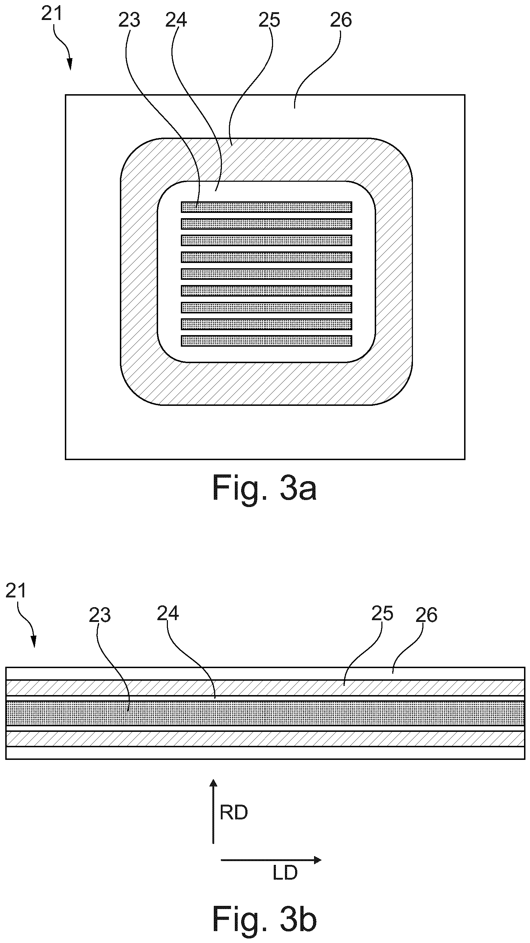

Fig. 3a and Fig. 3b show a superconductor cable according to an embodiment. The views of Fig. 3a and Fig. 3b correspond to the views of Fig. 2a and Fig. 2b, respectively. The elements with identical reference numerals shown in Fig. 3a and Fig. 3b may correspond to the elements shown in Fig. 2a and Fig. 2b but may be different.

As shown in Fig. 3a and Fig. 3b, the superconductor cable 21 comprises a layer of second metallic stabilizer material 26. The layer of ohmic heating material 25 is shown to be arranged entirely between the superconductor region (similar to superconductor region 19 shown in Fig. 2a) and the layer of second metallic stabilizer material 26. In the example of Fig. 3a, the layer of ohmic heating material 25 is shown to be entirely surrounding the layer of ohmic heating material 25. In the embodiment of Fig. 3a and Fig. 3b, the layer of second metallic stabilizer material 26 entirely surrounds the layer of ohmic heating material 25. In other embodiments, the layer of second metallic stabilizer material 26 may only partially surround the layer of ohmic heating material 25. the superconductor cable 21 has specific resistance characteristics. When, from a first position along the superconductor cable to a second position along the superconductor cable, the high temperature superconductor material is in a non-superconducting state, the superconductor cable 21 has:

a) a first resistance, Rnz, determined for current passing through the superconductor region 19 from the first position to the second position, and

b) a second resistance, Rbypass, determined for current not passing through the superconductor region 19 from the first position to the second position.

The ratio of Rnz to Rbypass is at least 1. This ratio ensures that when a non-superconducting zone develops, the current is effectively redirected through the layer of ohmic heating material 25, promoting rapid quench propagation along the length of the cable.

In some embodiments, this ratio may be larger than 0.8, preferably 1.0, preferably larger than 1.0, preferably 1.5, preferably 2, preferably larger than 2, preferably 4, preferably larger than 4, preferably 5, preferably larger than 5, preferably larger than 8, preferably 8, preferably larger than 10, preferably 10, preferably larger than 20. In some embodiments, said ratio is below 50, in some embodiments below 30, in some embodiments below 25.

To this end but also independently, the layer of first metallic stabilizer material 24 and/or layer of second metallic stabilizer material 26 may be selected from materials and/or have dimensions selected to fulfill the above ratio. For example, the first metallic stabilizer material 24 and/or layer of second metallic stabilizer material 26 may be selected from materials or composites with the suited resistance in comparison to the resistance per unit length of the layer of ohmic heating material.

Choosing this ratio accordingly will allow a beneficial behavior of the superconducting cable in case of a quench. This will be explained in detail with reference to Fig. 3c.

Fig. 3c shows behavior during a quench of a superconductor cable according to an embodiment.

The superconductor cable 21 or Fig. 3c may be the superconductor cable according to Fig. 3a and Fig. 3b. The stack of high temperature superconductor tapes 23 may carry a steady state current $I_o$. If a non-superconducting zone 50 develops, the stack of high temperature superconductor tapes 23 is no longer superconducting in zone 50, leading to an increased resistivity within zone 50. Therefore, the current $I_o$ arriving at the non-superconducting zone 50 redistributes and only a small amount may pass through the non-superconducting zone 50 as illustrated by the dotted arrow in Fig. 3c. As illustrated by the thick arrows of Fig. 3c, the majority of current or at least a part of the current may flow through first metallic stabilizer material 24 and/or the second metallic stabilizer material 26. The way the current splits between the dotted arrow in Fig. 3c and the other arrows may be determined by the ratio of the first resistance, Rnz, and the second resistance, Rbypass, for the bypassing current as described herein.

In the region behind the non-superconducting zone 50, the stack of high temperature superconductor tapes 23 is still superconducting, so that the current predominantly propagates inside the stack of high temperature superconductor tapes 23 as indicated by arrow $I_1$.

As the layer of ohmic heating material 25 has a comparatively high resistance, only a small fraction of current will flow along the layer of ohmic heating material 25. However, for reaching the layer of second metallic stabilizer material 26, the current needs to pass through the ohmic heating material 25, creating localized heat source regions 60 in the process. The heat generated at the local heat source region 60 may advantageously modify the behavior of the superconductor cable 21 during a quench. Superconductor cables according to other embodiments may work with similar mechanisms. For example, in the embodiments according to Fig. 2a and Fig. 2b, the superconductor cable 21 may be embedded inside a metallic stabilizer material so that the mechanism similar to the mechanism shown in Fig. 3c may form. In other examples, an assembly of cables may be used to provide similar effects. In such examples, the current bypassing a non-superconducting zone like non-superconducting zone 50 in Fig. 3c may bypass this zone via an adjacent superconductor cable or via an adjacent turn of the same cable. This will be further detailed below with the reference to additional embodiments.

To further optimize the quench behavior, layers may be added, modified, or removed.

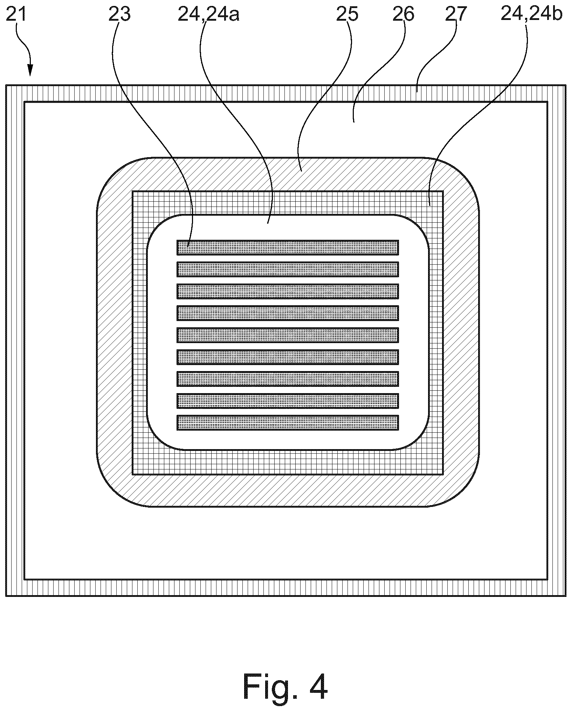

Fig. 4 shows a further embodiment. Namely, Fig. 4 shows a cross section of a cable which may be based on the cable shown in Fig. 2a and or Fig. 3a. In the embodiments according to Fig. 4, the first metallic stabilizer material 24 further comprises a metallic jacket layer 24b. The metallic jacket layer 24B may be made of different material from the remaining first metallic stabilizer material 24 shown in Fig. 4. For example, the first metallic stabilizer material 24 may be solder and the metallic jacket layer 24b may be Aluminium or another metal. The same applies to other layers which may also be formed from combination of different materials.

Independently or in combination as shown in Fig. 4, superconductor cable 21 may comprise a layer of insulation material 27 surrounding the layer of second metallic stabilizer material 26. the layer of insulation material 27 may have a resistivity of at least $1 \cdot 10^4$ Ohm · m, preferably of at least $1 \cdot 10^7$ Ohm · m. However, other values are possible as described herein. In the example of Fig. 4, the layer of insulation material 27 is surrounding the layer of second metallic stabilizer material 26. However, additional layers of insulation material may be present or the layer of insulation material 27 may be at a different position. In some embodiments, the layer of insulation material 27 only partially surrounds the layer of second metallic stabilizer material 26.

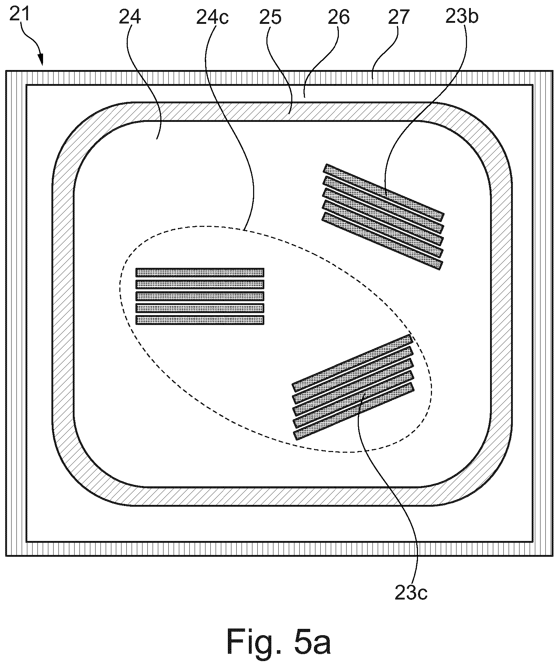

Fig. 5a shows a cross section of a superconductor cable according to an embodiment.

The superconductor cable 21 may share features with the superconductor cables explained above, for example with reference to at least one of figures 2a, 2b, 3a, 3b, 3c, and 4. The superconductor cable 21 shown in Fig. 5a further comprises at least one second high temperature superconductor material, optionally at least one second stack of high temperature superconductor tapes 23b. Additionally, as shown in the example of Fig. 5a, the superconductor cable 21 may further comprise at least one third high temperature superconductor material, optionally at least one third stack of high temperature superconductor tapes 23c.

Optionally, the superconductor cable 21 may also include at least one fourth high temperature superconductor material, optionally at least one fourth stack of high temperature superconductor tapes or additional high temperature superconductor materials (not shown in Fig. 5a).

The high temperature superconductor material 23, the at least one second high temperature superconductor material 23b, the at least one third high temperature superconductor material 23c, and/or the optional at least one fourth high temperature superconductor material may be arranged in one or more of the following configurations:

electrically insulated from each other,

electrically connected with each other,

connected by a third metallic stabilizer material 24c, at least partially or entirely surrounded by the layer of ohmic heating material 25.

In the example of Fig. 5a, the stack of high temperature superconductor tapes 23, the at least one second stack of high temperature superconductor tapes, and the at least one third stack of high temperature superconductor tapes are entirely surrounded by the layer of ohmic heating material 25. In Fig. 5a, The stack of high temperature superconductor tapes 23 and the at least one third stack of high temperature superconductor tapes 23c are connected by a third metallic stabilizer material 24c. However, this is merely for illustration. In other embodiments the third metallic stabilizer material 24c may be absent. In some examples, the insulation may be a partial insulation, for example preventing a direct electrical connection between the stacks of high temperature superconductor tape but still allowing an indirect electrical connection, for example via the ohmic heating material 25. This may further optimize the quench behavior of the superconductor cable.

In some embodiments, the stack of high temperature superconductor tapes 23 and/or the at least one second stack of high temperature superconductor tapes and/or the at least on third stack of high temperature superconductor tapes may be twisted along a length of the superconductor cable 21. This is schematically shown in Fig. 5a for the at least one second stack of high temperature superconductor tapes 23b, and the at least one third stack of high temperature superconductor tapes 23c. However, also the stack of high temperature superconductor tapes 23 in Fig. 5a or the other figures may be twisted and combinations of some stacks or other superconductor materials which are twisted and other stacks which are not twisted are also possible.

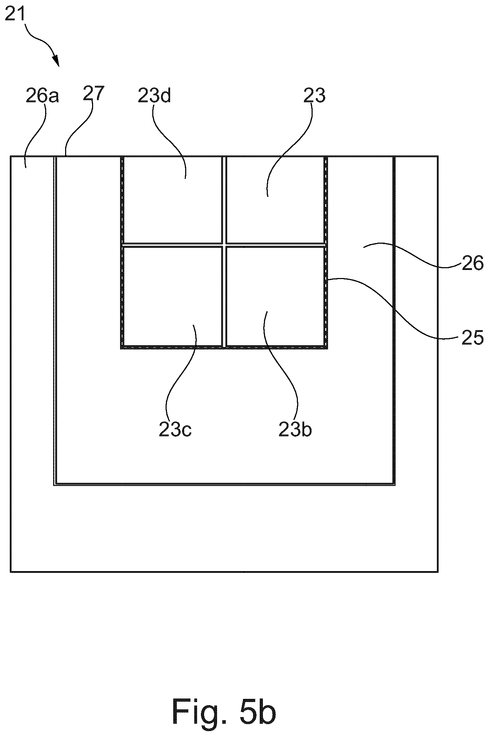

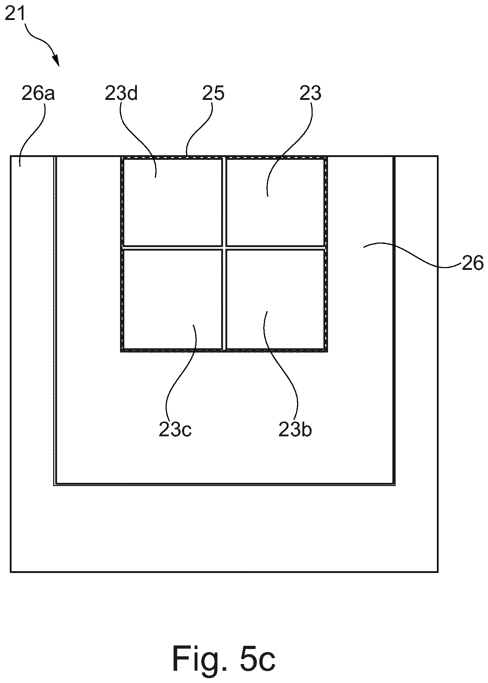

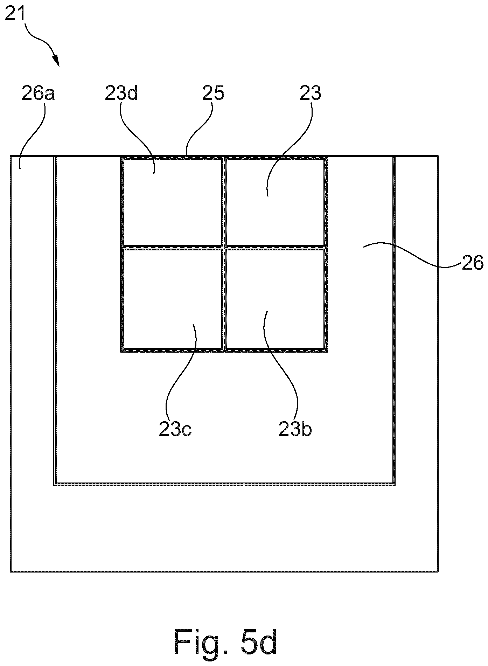

Fig. 5b, Fig. 5c, and Fig. 5d shows cross sections of different superconductor cable according to various embodiments.

Similar to Fig. 5a, each of Fig. 5b, Fig. 5c, and Fig. 5d illustrate a cross-sectional view of a superconductor cable 21 according to various embodiments. The features with identical reference signs may correspond to features described herein, for example with reference to other figures, for example with reference to Fig. 2a, Fig. 3a, Fig. 4 etc.

In some embodiments, at least one, several, or all of Fig. 5b to Fig. 5d may be to scale. In such embodiments, the width and height of high temperature superconductor tape 23 may be 6 mm and 6 mm, respectively. In other examples, the width and height of high temperature superconductor tape 23 may be 8 mm and 8 mm, respectively. In those embodiments, from the dimension given the dimensions of the elements for the specific embodiments shown may be determined. However, this is only exemplary and other dimensions are possible in other embodiments. In other embodiments, Fig. 5b to Fig. 5d are not to scale and for example the high temperature superconductor tape 23 may have non-square dimensions, for example 6 mm width by 8 mm height. Other dimensions and shapes are possible as well.

The superconductor region comprises high temperature superconductor material, for example high temperature superconductor tapes 23 which may correspond to the high temperature superconductor tapes discussed with respect to other embodiments. Further, the examples of Fig. 5b to Fig. 5d have additional high temperature superconductor materials, specifically a second stack of high temperature superconductor tapes 23b, a third stack of high temperature superconductor tapes 23c, and a fourth stack of high temperature superconductor tapes 23d. While shown as stacks, in other embodiments other high temperature superconductor material may be used. The second to fourth stack may have similar or identical properties as high temperature superconductor tapes 23. The stacks and/or superconductor materials may also have properties differing from each other, for example may be made from different high temperature superconductor materials and/or be a mixture of tapes and non-tape high temperature superconductors.

The different high temperature superconductor materials may be connected and/or embedded by a first metallic stabilizer material (not shown) as first metallic stabilizer material 24 discussed with respect to other figures and embodiments.

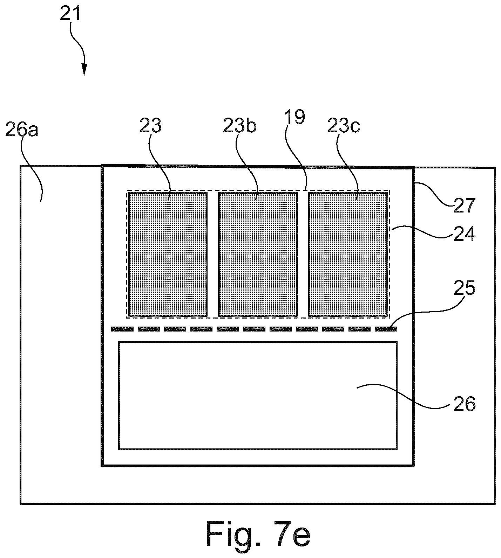

In Fig. 5b, a layer of insulation material 27 surrounds the layer of second metallic stabilizer material 26, creating an insulation for example with respect to conductive support structure 26a. This may be similar to the arrangement of the layer of insulation material 27 as shown in Fig. 7e.

As shown in Fig. 5b, the layer of ohmic heating material only partially surrounds the superconductor region. However, due to the layer of insulation material 27 a current from a no longer superconducting region must still pass through the layer of ohmic heating material 25 when transitioning into the second metallic stabilizer material.

Due to the layer of insulation material 27, a current leaving the superconductor region may not be able to cross into conductive support structure 26a.

Fig. 5c shows an example which corresponds to Fig. 5b. However, in the example of Fig. 5c no layer of insulation material is present. In the example of Fig. 5c, the layer of ohmic heating material 25 entirely surrounds the superconductor region. As in the example of Fig. 5c, no layer of insultation material is present, a current leaving the superconductor region may be able to cross into conductive support structure 26a.

Fig. 5d corresponds to Fig. 5a. In Fig. 5d, the layer of ohmic heating material 25 at least partially surrounds the superconductor region. In Fig. 5d, the layer of ohmic heating material 25 it is schematically shown to entirely surround the superconductor region. Further, the layer of ohmic heating material 25 may separate the superconductor region into sub-regions. In the example of Fig. 5d, the layer separates the superconductor region into four sub-regions, wherein each sub-region comprises different superconductor material. Namely, in the example of Fig. 5c, a first sub-region comprises the stack of high temperature superconductor tapes 23, the second sub-region comprises the second stack of high temperature superconductor tapes 23b, the third sub-region comprises the third stack of high temperature superconductor tapes 23c and the fourth region comprises the fourth stack of high temperature superconductor tapes 23d. If one of the sub-regions becomes non-superconducting, the current may bypass this region via one of the other sub-regions. For example, if the second stack of high temperature superconductor tapes 23b becomes non-superconductive, the current carried by the second stack of high temperature superconductor tapes 23b may predominantly diverge to the stack of high temperature superconductor tape 23 and the third stack of high temperature superconductor tapes 23c due to the geometric proximity. By the arrangement of the layer of ohmic heating material 25 as described with reference to Fig. 5d, also the bypassing via sub-regions may generate an ohmic heating in the layer of ohmic heating material 25. This may improve the quench behavior of cable 21.

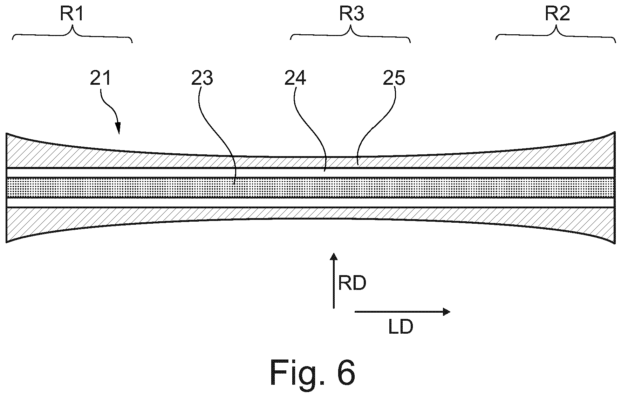

Fig. 6 shows a superconductor cable according to an embodiment. Fig. 6 shows a cross section view along the length LD of the superconductor cable 21. While superconductor cable 21 of Fig. 6 is shown with layers as shown and discussed with reference to Fig. 2 and Fig. 2b, the same principle can be applied to superconductor cables with other layers as discussed herein, for example Fig. 5.

In the embodiment of Fig. 6, the local thickness and/or resistivity of the ohmic heating material 25 in a region at the start along the length of the superconductor cable 21 and in a region at the end along the length of the superconductor cable 21 are different from the local thickness and/or resistivity of the ohmic heating material in a region in the middle along the length of the superconductor cable. Note that in the example of Fig. 6 the variation of the local thickness is shown. In some embodiments the local thickness may remain essentially the same along the length, but only the resistivity of the layers, for example the ohmic heating material 25, may change. However, combinations are possible. For example, the local thickness may change and at the same time local resistivity may change, for example of the ohmic heating material 25 and/or the first metallic stabilizer material 24 and/or the second metallic stabilizer material 26.

The thickness and/or resistivity of a layer of ohmic heating material 25 may change along the length of the superconductor cable 21. This is shown in the example of Fig. 6 to as a change in radial direction RD as a function of direction along the length LD of the cable 21. For example, the local thickness and/or resistivity of the ohmic heating material 25, for example the surface resistivity of the ohmic heating material, in a region at the start R1 along the superconductor cable 21 and/or in a region at the end R2 may be different from the local thickness and/or resistivity of the ohmic heating material 25 in a region in the middle R3 along the length of the superconductor cable 21. In the example of Fig. 6, this variation is shown to be symmetric to center of the cable, but the change can also be asymmetric. Other changes as a function of length along the cable are possible. In some examples and as shown in Fig. 6, the thickness and/or resistivity, for example the surface resistivity, of the ohmic heating material 25 in a region in the middle R3 along the length of the superconductor cable 21 is smaller than the thickness and/or resistivity, for example the surface resistivity, of the ohmic heating material 25 in a region at the start R1 and/or the end R2 along the length of the superconductor cable 21.

In some embodiments, the resistivity may be a bulk resistivity. In other embodiments, the resistivity may be a surface resistivity.

**Materials**

In the figures discussed above as well as in the figures discussed below, various combinations of materials can be used, for example for the different layers mentioned. The material may be selected to improve the behavior of the superconductor cable during a quench as explained for example with reference to Fig. 3c. The following non-limiting examples for materials are given.

A stack of high temperature superconductor tapes 23 may be a 8 mm by 8 mm stack containing about 140 tapes stacked on each other. However, also other dimensions and numbers of tape stacks are possible, for example as shown and discussed with respect to Fig. 5b to 5d. The stack of high temperature superconductor tapes may be connected by the first metallic stabilizer material 24 as shown in Fig. 2a.

The first metallic stabilizer material 24 may comprise at least one of the following: solder, copper, copper alloy, brass, aluminium, aluminium alloy. Combinations are possible, for example can the first metallic stabilizer material be made of solid copper in between the stack of high temperature superconductor tape and be made of solder in an area surrounding the stack of high temperature superconductor tape 21 shown for example in Fig. 2a. Other combinations are possible as well.

The second metallic stabilizer material 26 may enhance the performance of the superconductor cable during a quench. The second metallic stabilizer material may be at least one of the following materials: solder, copper, copper alloy, brass, aluminium, aluminium alloy, and/or a high-strength material such as steel. The selection of the second metallic stabilizer material may improve mechanical stability of the superconductor cable or the superconductor cable assembly as well as thermal properties, for example during a quench.

For instance, using a combination of copper and aluminium for the second metallic stabilizer material 26 may enhance both the electrical and thermal conductivity, thereby improving the overall stability of the superconductor cable during a quench. The high-strength materials, such as steel, may provide the necessary mechanical support to withstand the thermal and mechanical stresses during operation. By combinations of materials, further optimization may be achieved.

In some embodiments, the second metallic stabilizer 26 further comprises a conductive support structure 26a. The conductive support structure 26a may comprise at least one of the following materials: stainless steel, titanium, composite carbon fibre, inconel, nitronic alloy, high strength alloys. The superconductor cable may be embedded in this conductive support structure 26a.

The layer of ohmic heating material 25 may comprise at least one of the following materials: silicon carbide, semi-metals, semiconductors, anodised aluminium, matrix composites.

A layer of insulation material may comprise at least one of the following materials: : organic insulators, polyimide, inorganic insulators, ceramic, non-conductive epoxy, a glass fibre matrix, insulation paper, insulating lacquer, paint. The above materials, for example in film and/or tape form may be used. In some embodiments, non-conductive epoxy is used alternatively or in addition. In some examples, stycast in a glass fibre matrix is used. In other embodiments, insulation paper, insulating lacquer and/or paint is used. Also, combinations of the insulation materials mentioned can be used.

In some embodiments, a metallic jacket layer comprises at least one of the following materials: a high-conductive material, solder, copper, copper alloy, aluminium or aluminium alloy, a high-strength material, steel.

By combining these materials, further optimization of electrical, thermal, and mechanical properties can be achieved, enhancing the overall performance, safety and/or stability of the superconductor cable, particularly during quench events.

In the following, further embodiments are described.

**Superconductor cable assemblies**

In some embodiments, superconductor cable assemblies are provided. The superconductor cable assemblies may be superconductor magnetic field coils. The superconductor magnetic field coils may comprise a plurality of turns of a superconductor cable, for example of the superconductor cables according to the embodiments described herein. In other embodiments, the superconductor cable assembly may comprise a plurality of superconductor cables, for example of superconductor cables described herein.

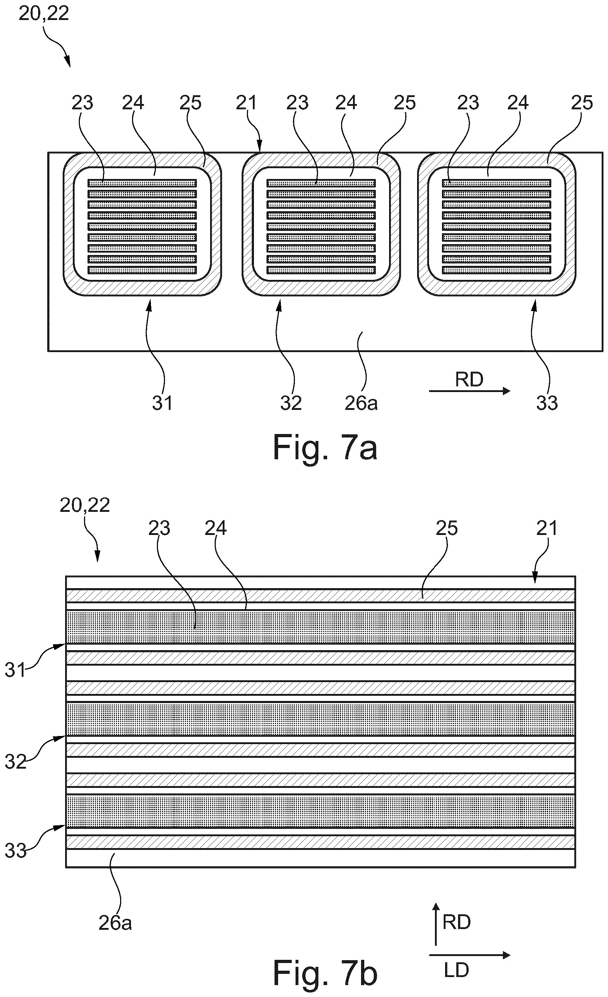

Fig. 7a and Fig. 7b show a superconductor cable assembly 22 according to an embodiment. Fig. 7a shows cross section of the superconductor magnetic field coil 20. Fig. 7a shows a radial section of the cable assembly 22, in other words a cross section view perpendicular to the length of the cable 21 comparable to the views shown in Fig. 2a, 3a, 4, and 5 as well as other figures. Fig. 7b shows an axial section of a part of the cable assembly 22, in other words a cross section view along the length of the cable 21, comparable to the views shown in Fig. 2b, 3b and other figures.

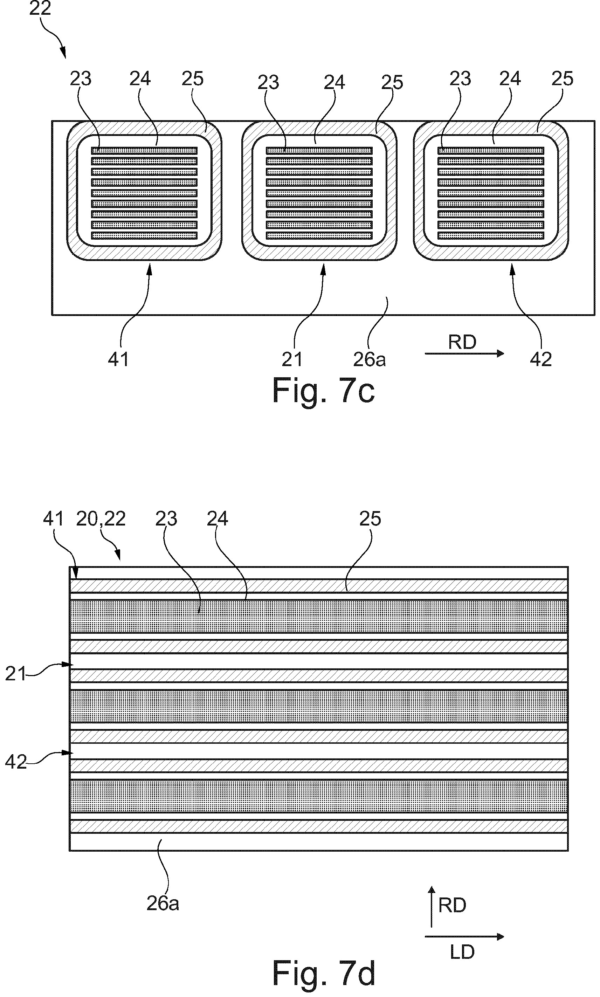

The superconductor cable assembly may be a superconductor magnetic field coil 20, preferably a planar magnetic field coil 20a or a non-planar magnetic field coil 20b for a stellarator 1 as shown in Fig. 1. The superconductor magnetic field coil 20 may have a plurality of turns 31, 32, 33. The coil may be made from a single superconductor cable 21. However, in other embodiments the cable assembly 22 may comprise a plurality of superconductor cables 21, 41, 42. This will be explained with reference to Fig. 7c and 7d below.

In one embodiment, a superconductor cable assembly 22 is provided. The superconductor cable assembly 22 may be the superconductor cable assembly 22 shown in Fig. 7a and Fig. 7b and/or the superconductor cable assembly 22 shown in Fig. 7c and Fig. 7d. Regardless, the superconductor cable assembly 22 may comprise at least one superconductor cable 21, the superconductor cable 21 comprising:

a superconductor region, for example as superconductor region 19 explained with reference to Fig. 2a above. The superconductor region may comprise:

high temperature superconductor material, optionally high temperature superconductor tapes 23 and a first metallic stabilizer material 24. The superconductor cable may further comprise a layer of ohmic heating material 25 at least partially surrounding the superconductor region 19.

As shown in Fig. 7a and Fig. 7b, the superconductor cable assembly 22 may further comprise a layer of second metallic stabilizer material 26 at least partially or entirely surrounding the layer of ohmic heating material 25.

A thickness and resistivity of the layer of ohmic heating material 25 may be configured such that a first velocity, v1, of a non-superconducting zone propagation along the superconductor cable 21 is larger than a second velocity, v2, of non-superconducting zone propagation in a radial direction of the superconductor cable assembly 22.

As illustrated in Fig. 7a and Fig. 7b and Fig. 7c and Fig. 7d, the layer of second metallic stabilizer material 26 maybe a solid block of material, for example a conductive support structure 26a. However, different metallic stabilizer materials 26 are possible which may not act as support structure. In some embodiments, the second metallic stabilizer 26 further comprises a conductive support structure 26a.

In some embodiments, the layer of second metallic stabilizer material 26 may be shared between several turns of the superconductor cable 21, for example turns 31, 32, and 33 shown in Fig. 7a and Fig. 7b. This may reduce weight, the amount of required material, increase mechanical stability of cable assembly 22, and/or simplify of manufacturing of cable assembly 22.

A thickness and resistivity of the layer of ohmic heating material 25 may be configured such that a first velocity v1 of a non-superconducting zone propagation along the superconductor cable is larger than a second velocity v2 of non-superconducting zone propagation in a radial direction of the superconductor cable assembly 22.

Fig. 7c and Fig. 7d show a superconductor cable assembly 22 according to an embodiment.

As illustrated in Fig. 7c and Fig. 7d, the layer of second metallic stabilizer material 26 maybe a solid block of material. In some embodiments, the layer of second metallic stabilizer material 26 is used by several turns of the superconductor cable 21, for example turns 31, 32, and 33 as shown in Fig. 7a. However, in the example of Fig. 7c and Fig. 7d, the superconductor assembly 22 comprises a plurality of superconductor cables 21, 41, 42. In other words, if for example the cable assembly 22 shown in Fig. 7a comprises a first cable, for example superconductor cable 21, and a second superconductor cable 41, both superconductor cables may use the layer of second metallic stabilizer material, for example in conductive support structure 26a. This may reduce weight, amount of required material, mechanical stability of cable assembly 22, and /or increase simplicity of manufacturing.

Fig. 7e shows another embodiment of a superconductor cable 21 which may be part of a superconductor cable assembly. The features of cable 21 may correspond to features explained with reference to the previous figures, for example Fig. 5b. Different from Fig. 5b, in Fig. 7e three different high temperature superconductor materials are present, namely a stack of high temperature superconductor tapes 23, a second stack of high temperature superconductor tapes 23b, and a third stack of high temperature superconductor tapes 23c. In other embodiments, different high temperature superconductors or combinations may be used, for example non-tape high temperature superconductors. Fig. 7e illustrates that the layer of ohmic heating material 25 may be arranged at least partially between the superconductor region 19 and the layer of second metallic stabilizer material 26. In the example of Fig. 7e, the layer of insulation material 27 ensures that at least a significant part of any current leaving the superconductor region passes through the layer of ohmic heating material 25, thereby mitigating the quench. In other words, in Fig. 7e the layer of ohmic heating material partially surrounds the superconductor region 19.

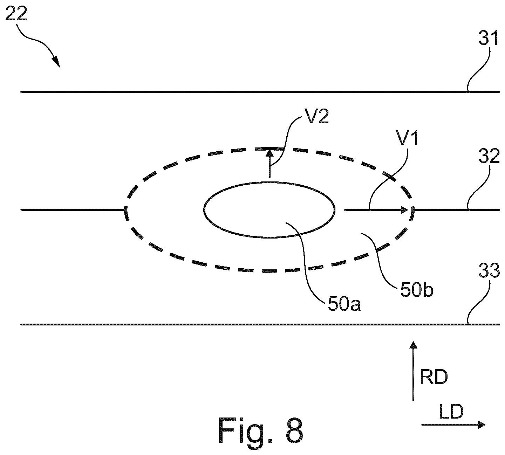

Fig. 8 shows an example of non-superconducting zone propagation according to an embodiment. As shown in Fig. 8, at a first time t1 in turn 32 which may be turn 32 of cable assembly 22, a non-superconducting zone 50a develops. Consequently, the current bypasses the non-superconducting zone developing in the stack of high temperature superconductor tapes 23 shown in Fig.

7a. Thus, the current passes instead predominantly through the first metallic stabilizer material 24, the layer of ohmic heating material 25, and the layer of second metallic stabilizer material 26, 26a. As the thickness and resistivity of the layer of ohmic heating material is configured according to an embodiment, the first velocity V1 of the non-superconducting zone propagation along the superconductor cable, in this case along turn 32 of superconductor cable 21 shown in Fig. 7a, is larger than the second velocity V2 of non-superconducting zone propagation in the radial direction RD of the cable assembly 22. In other words, the non-superconducting zone propagates faster along the superconductor cable than across cables in the cable assembly. Thus, at a time t2 the non-superconducting zone has expanded to non-superconducting zone 50b.

Note that in Fig. 8 the layers of superconductor cable in turns 31, 32, 33 of superconductor cable assembly 22 are omitted for clarity. As a result of the configuration according to an embodiment the velocity V1 is increased and thus the quench behavior of the superconductor cable assembly 22 is improved.

Based on variation of the thickness and the number of involved layers, the behavior during a quench may be modified. For example, by increasing the thickness of the layer of ohmic heating material the local heat during a local quench may be increased.

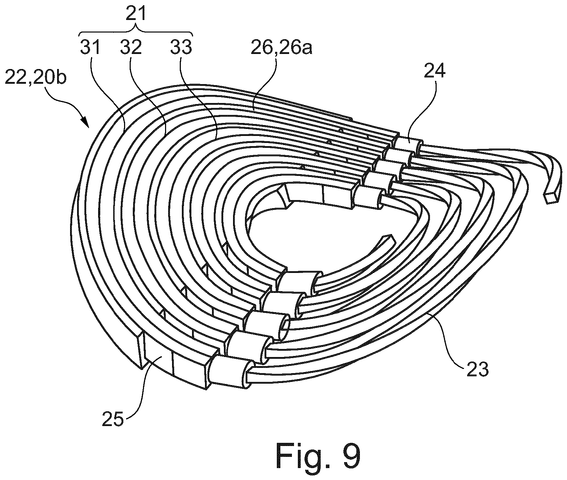

Fig. 9 shows a superconductor cable assembly 22 configured as a non-planar magnetic field coil 20b according to an embodiment.

The superconductor cable assembly 22 comprises a plurality of turns 31, 32, 33 of a superconductor cable 21. Each turn of the superconductor cable 21 includes a stack of high temperature superconductor tapes 23 embedded in a first metallic stabilizer material 24. The stack of high temperature superconductor tapes 23 is at least partially surrounded by a layer of ohmic heating material 25. The layer of ohmic heating material 25 is further surrounded by a layer of second metallic stabilizer material 26, 26a.

Fig. 9 shows the superconductor cable 21 arranged in a spiraling configuration, forming multiple turns, for example turns 31, 32, 33 to form the superconductor magnetic field coil 20b.

The second metallic stabilizer material 26, 26a, which surrounds the layer of ohmic heating material 25, further enhances the thermal and electrical stability of the superconductor cable 21 and/or may contribute to an improved quench behavior as explained with reference to Fig. 3c and 8.

As illustrated in Fig. 9, the conductive support structure 26a may be part of the second metallic stabilizer material 26. This support structure may be made from materials such as stainless steel or titanium, providing additional mechanical strength and support to the superconductor cable assembly 22. In some embodiments, the superconductor cable comprises an additional or exclusive layer of second metallic stabilizer material. In other examples, the superconductor cable may not include a layer of second metallic stabilizer material and the support structure may have the effect of the second metallic stabilizer material as explained with reference to Fig. 3c above. In other embodiments, a combination is provided where the second metallic stabilizer material is formed by a combination of second metallic stabilizer material as explained above and a support structure.

While Fig. 9 was explained with respect to stacks of superconductor material other superconductor materials are possible as well as explained herein.

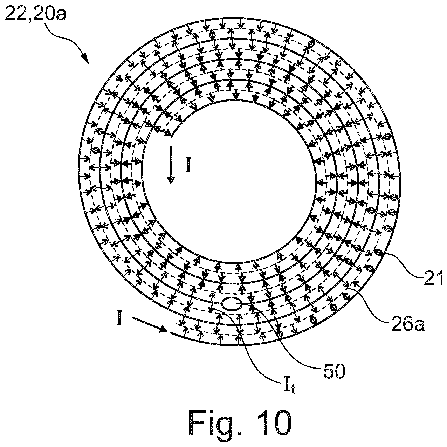

Fig. 10 shows a cross-sectional view of a superconductor cable assembly 22 which is a superconductor magnetic field coil 20 according to an embodiment.

The superconductor magnetic field coil shown in Fig. 10 is a planar magnetic field coil, but the principles may also apply to a non-planar magnetic field coil. The magnetic field coil comprises multiple turns of a superconductor cable 21 arranged in a concentric manner. The superconductor cable 21 is depicted as being embedded within a conductive support structure 26a, which provides mechanical stability and electrical conductivity. As previously explained, the conductive support structure 26a may be part of or form the second metallic stabilizer. The conductive support structure 26a is shown surrounding the superconductor cable 21, ensuring uniform distribution of mechanical stresses and aiding in thermal management during a quench as previously described. The superconductor cable 21 itself consists of a stack of high temperature superconductor tapes and may be a superconductor cable as described herein. The first metallic stabilizer material and the ohmic heating layer are not explicitly labeled.

Additionally, Fig. 10 shows a non-superconducting zone 50, which is shown as a localized region within superconductor magnetic field coil 20. This non-superconducting zone 50 is indicative of a transition from the superconducting state to a non-superconducting state, which can occur due to various factors such as thermal disturbances or excessive current. As indicated by the arrows in Fig. 10, the non-superconducting zone 50 in one of the turns 31, 32, 33 of the superconductor magnetic field coil 20 may propagate along the complete turn or partially along the turn before an adjacent turn becomes non-superconducting. This may contribute to an improved propagation of the non-superconducting zone and may improve quench behavior of the magnetic field coil, for example at least partially preventing damage to the cable 21 and/or superconductor magnetic field coil 20.

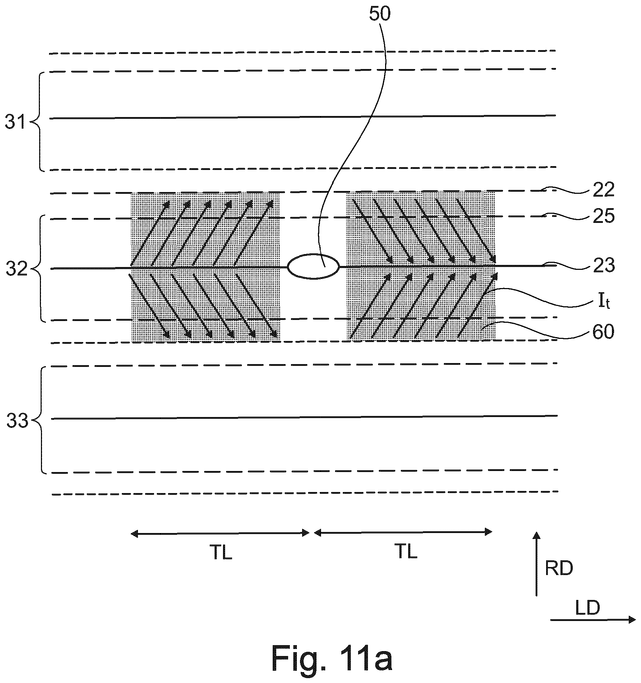

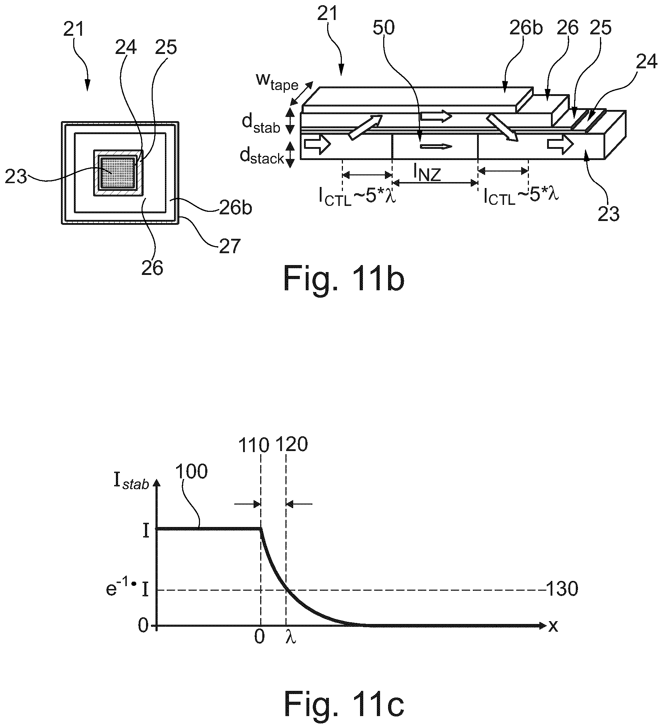

Fig. 11a shows a sectional view of a superconductor cable assembly 22 according to an embodiment. Specifically, Fig. 11 shows the arrangement and interaction of various components within the assembly. The Fig. depicts three turns 31, 32, and 33 of a superconductor cable 21, which are part of a superconductor magnetic field coil. The superconductor cable 21 comprises a stack of high temperature superconductor tapes 23 embedded in a first metallic stabilizer material not explicitly labeled in the Fig.

As shown in Fig. 10, the ohmic heating material 25 contributes to improving the quench behavior. In order to get into the stabilizer e.g. the layer of second metallic stabilizer material 26 or the conductive coil support structure 22, the current has to pass through the ohmic heating material 25. This will increase the current transfer length TL and introduce extra ohmic heating in local heat source regions 60 within these lengths as shown in Fig. 11. This added transverse current heating increases the first velocity v1 as explained with reference to Fig. 8.

Fig. 11b shows a cross-section of a superconductor cable 21. The cable may be similar to the superconductor cable 21 explained elsewhere, for example with reference to Fig. 2a, Fig. 3a, and Fig. 4. In the embodiment of Fig. 11b the layer of metallic stabilizer material 26 comprises a further layer of metallic stabilizer material 26b. This illustrates that in general the layer of metallic stabilizer material may comprise a plurality of layers with different properties, for example selected from different materials, for example from copper, copper alloys, brass, solder etc as described herein.

Further, Fig. 11b shows a schematic side view of cable 21. Similar to Fig. 3c, arrows indicate the path a current may take as a non-superconducting zone 50 develops. In a slab model, the non-superconducting zone may have length $l_{NZ}$ at a given time. With a width of the cable $w_{tape}$ and a thickness of the layer of second metallic stabilizer material $d_{stab}$ and a thickness of the superconductor material $d_{stack}$, a current profile as shown in Fig. 11c may develop. As can be seen from Fig. 11c, a current transfer length, λ, may show how the current curve 100 behaves as a function of position x based on the current transfer length. As can be seen in fig. 11c, between position 110 and position 120 the current decreases by a factor of $e^{-1}$ (see dashed line 130). The relationship may be governed by

$$I_{stab}(x) = Ie^{-x/\lambda},$$

Wherein λ may be given by

$$\lambda = \sqrt{\frac{v\ d_{stab}}{\rho}},$$

wherein ρ is the bulk resistivity of the layer of ohmic heating material 25 and v is the surface resistivity of the ohmic heating material.

In some embodiments, the superconductor cable and/or the superconductor cable assembly is designed so that the current transfer length is large, for example at least 0.5 m, for example at least 0.75 m, for example at least 1 m, for example at least 2 m, for example many meters, for example at least 10 m.

The thermal capacity of the second metallic stabilizer may depend on the volume, in the example of Fig. 11b the thermal capacity may be proportional to the product $d_{stab} \cdot w_{tape}$. The thermal capacity may be selected sufficiently large to be able to retain a sufficient part of the heat generated during a quench. Further factors influence this, for example the first stabilizer, cable dimensions and geometry etc.

Selection of materials and cable dimensions based on the above equations may be a way to at least partially control the ratio between Rbypass and Rnz as described herein.

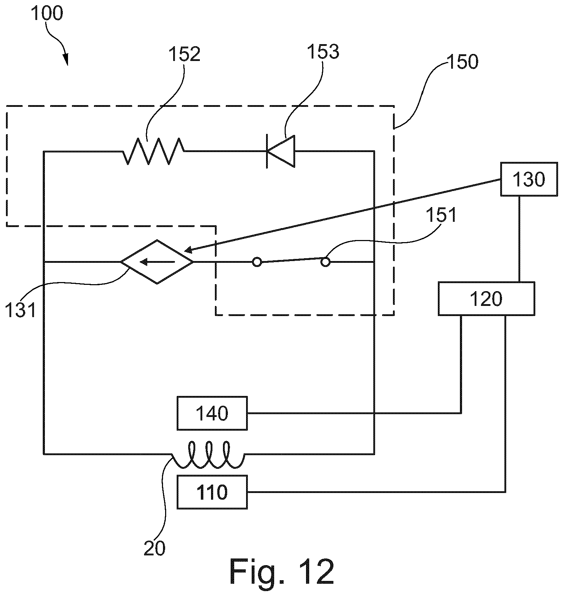

Fig. 12 shows a system 100 for preventing damage to at least one superconductor cable assembly 22 according to an embodiment.

The system 100 comprises at least one sensor 110 connected to the at least one superconductor cable assembly 22. The at least one sensor 110 may be a current and/or a temperature sensor. The system 100 further comprises a power control unit 130 connected to the at least one superconductor cable assembly 22 and at least one non-superconducting zone generation means 140 connected to the at least one superconductor cable assembly 22. The system may comprise further components, for example a dump circuitry 150 and a control unit 120.

The control unit 120 may be operably connected to the at least one sensor 110, the power control unit 130, the at least one non-superconducting zone generation means 140 and may optionally be connected to the dump circuitry 150.

The control unit 120 may be configured to determine that a local non-superconducting zone 50 has developed in at least one of the at least one superconductor cable assembly 22 based on the at least one sensor 110. For example, the control unit 120 may continuously monitor readings from the at least one sensor 110, for example current and/or temperature readings. For example, based on an analysis, the control unit 120 may determine, that a quench is starting in the at least on superconductor cable assembly. The control unit 120 may be configured, for example in reaction to this determining, to interrupt a connection to a power control unit 130 of the at least one superconductor cable assembly 22. This may be advantageous if a non-insulated superconductor cable assembly is used. In some embodiments, a non-insulated superconductor cable assembly may only require disconnection of the power control unit 130 to reach an improved quench behavior. In some embodiments, an interruption of the connection may not be necessary. In yet further embodiments, the interruption of the connection may not be sufficient and further steps may be required as described herein, for example the connection of a dump circuitry.

As shown in Fig 12, the control unit 130 may activate the non-superconducting zone generation means 140 to generate at least one additional non-superconducting zone in the at least one superconductor cable assembly 22. Further optionally, the control unit 130 may connect a dump circuitry 150 to the at least one superconductor cable assembly 22, for example superconductor magnetic field coil 20, 20a, 20b.

The non-superconducting zone generation means 140 may be at least one of the following: at least one heating element attached to the at least one superconductor cable assembly 22, at least one alternating current generation means coupled to the at least one superconductor cable assembly 22.

In some embodiments, the superconductor cable has at least one region of low critical current. Then, this region may be quenched by briefly increasing a current in the superconductor cable above the low critical current value. This may have the advantage that by design the region, in which the quench starts to occur is predetermined.

In some embodiments, the non-superconducting zone generation means may be a controller configured to briefly raise the current carried in the cable assembly, for example above a threshold value, for example above the low critical current of the cable.

In some embodiments, the non-superconducting zone generation means may comprise removing at least part of the cooling from at least a part of the at least one superconductor cable assembly.

In some embodiments, the non-superconducting zone generation means may comprise energizing an electromagnet in proximity to the at least one superconductor cable assembly.

The electromagnet may cause a local rotation of the net magnetic field vector inside the superconductor material. In some superconductor materials, for example in some high temperature superconductor tapes, for example in ReBCO tapes, the critical current may be very sensitive to the net magnetic field vector, thereby allowing triggering of a quench by the non-superconducting zone generation means.

Upon detection of formation of a non-superconducting zone, the control unit 120 may interrupt the connection between the power control unit 130 and the superconductor cable assembly 22. The system may optionally activate non-superconducting zone generation means 140, for example at least one heating element 140, to generate an additional non-superconducting zone to manage the spread of the initial non-superconducting zone.

The dump circuitry 150 may comprise a resistor 152 and/or a diode 153 as shown in Fig. 12. The dump circuitry 150 may be used to control the flow of current and protect the system during the transition to a non-superconducting state. The control unit 120 may connect the dump circuitry 150 to the superconductor magnetic field coil 20 via a switch 151. Note that the components shown in Fig. 12 are optional.

In some embodiments, the superconductor cable according to embodiments of this disclosure is efficient at dumping a current during the quench itself into the volume of the superconductor cable. Thus, in some embodiments, the system does not require a dump circuitry or the dimensions of the dump circuitry may be reduced. In some embodiments, the dump circuitry may only comprise a switch instead of resistor 152 and/or diode 153. In some of those examples, the resistance of the superconductor cable according to an embodiment may act as a dump resistor.

The system 100 thus allows to provide a robust mechanism for detecting and managing non-superconducting zone development in at least one of a plurality of superconductor cable assemblies.

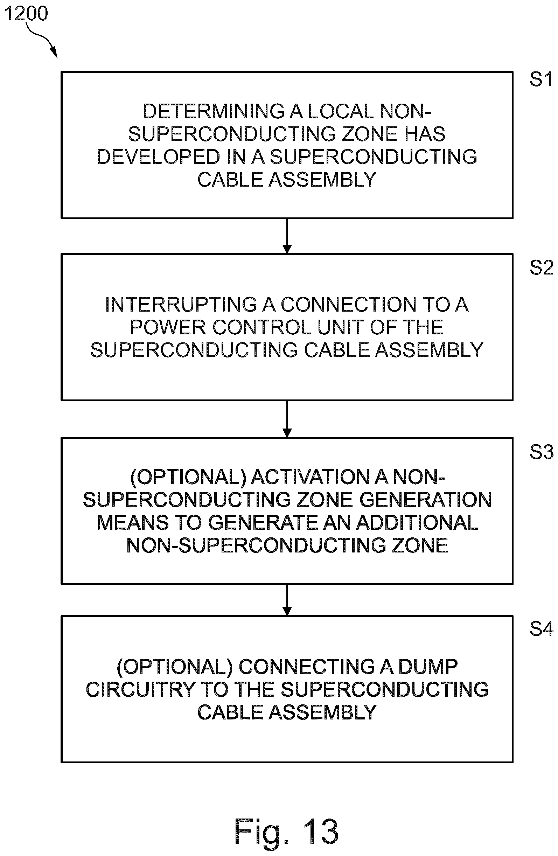

Fig. 13 shows a method 1200 for preventing damage to at least one superconductor cable assembly according to an embodiment. The method begins with step S1, which involves determining that a local non-superconducting zone 50 has developed in the at least one superconductor cable assembly 22. This determination may be made by a control unit 120 based on data from at least one sensor 110 as described previously.

In optional step S2, a connection of a power control unit 130 with the superconductor magnetic field coil 20, 20a, 20b is interrupted.

In optional step S3, at least one non-superconducting zone generation means is activated to generate at least one additional non-superconducting zone.

In optional step S4, a dump circuitry 150 is connected to the at least one superconductor cable assembly, for example at least one superconductor magnetic field coil 20, 20a, 20b.

As stated above, the non-superconducting zone generation means may be at least one of the following: at least one heating element 140 attached to the at least one superconductor cable assembly 22 and/or at least one alternating current generation means coupled to the at least one superconductor cable assembly 22.

The at least one superconductor cable assembly 22 may comprise a plurality of superconductor cable assemblies. The method may further comprise: In response to the determining that a local non-superconducting zone 50 has developed in the at least one superconductor cable assembly 22: performing at least one of the steps of interrupting, activating and connecting for all of the plurality of superconductor cable assemblies.

The method 1200 is designed to systematically address the development of non-superconducting zones within a superconductor cable assembly, ensuring that appropriate measures are taken to prevent damage and maintain the integrity of the system.

It should be noted that the at least one superconductor cable assembly 22 may be at least one superconductor magnetic field coil 20, 20a, 20b as explained above. In some embodiments, determining that a local non-superconducting zone 50 has developed in the at least one superconductor cable may comprise determining that a local non-superconducting zone 50 has developed in at least one of the turns 31, 32, 33 of at least one of the at least one superconductor magnetic field coil 20, 20a, 20b. Further, the at least one heating element may be attached to one or more turns of the plurality of turns 31, 32, 33.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

The invention may be further characterized by the following examples.

**Examples:**

Example 1. A superconductor cable (21) for a superconductor cable assembly (22), comprising:
a superconductor region, the superconductor region comprising:

high temperature superconductor material, optionally high temperature superconductor tapes (23) and

a first metallic stabilizer material (24); the superconductor cable further comprising:

a layer of ohmic heating material (25) at least partially surrounding the superconductor region;

wherein the layer of ohmic heating material (25) has a surface resistivity between $10^{-7}$ Ohm · m$^2$ and 1 Ohm · m$^2$, optionally between $10^{-7}$ Ohm·m$^2$ and 1 Ohm·m$^2$, optionally between $10^{-6}$ Ohm·m$^2$ and $10^{-1}$ Ohm·m$^2$, optionally between $10^{-5}$ Ohm·m$^2$ and $10^{-2}$ Ohm·m$^2$, optionally between $10^{-4}$ Ohm·m$^2$ and $10^{-3}$ Ohm·m$^2$, optionally between $2 \cdot 10^{-4}$ Ohm·m$^2$ and $5 \cdot 10^{-4}$ Ohm·m$^2$, optionally of approximately $3 \cdot 10^{-4}$ Ohm·m$^2$; and/or
and/or

wherein the layer of ohmic heating material (25) has a surface resistivity between $10^{-7}$ Ohm·m$^2$ and $3 \cdot 10^{-4}$ Ohm·m$^2$, optionally between $5 \cdot 10^{-7}$ Ohm·m$^2$ and $1.5 \cdot 10^{-4}$ Ohm·m$^2$, optionally between $1 \cdot 10^{-6}$ Ohm·m$^2$ and $7.5 \cdot 10^{-5}$ Ohm·m$^2$, optionally between $5 \cdot 10^{-6}$ Ohm·m$^2$ and $3 \cdot 10^{-5}$ Ohm·m$^2$, optionally between $10^{-5}$ Ohm·m$^2$ and $1.5 \cdot 10^{-5}$ Ohm·m$^2$, optionally between $3 \cdot 10^{-5}$ Ohm·m$^2$ and $1 \cdot 10^{-5}$ Ohm·m$^2$
and /or

wherein the layer of ohmic heating material (25) has a surface resistivity between $3 \cdot 10^{-4}$ Ohm·m$^2$ and 1 Ohm·m$^2$, optionally between $1 \cdot 10^{-3}$ Ohm·m$^2$ and $3 \cdot 10^{-1}$ Ohm·m$^2$, optionally between $3 \cdot 10^{-3}$ Ohm·m$^2$ and $1 \cdot 10^{-1}$ Ohm·m$^2$, optionally between $1 \cdot 10^{-2}$ Ohm·m$^2$ and $3 \cdot 10^{-2}$ Ohm·m$^2$, optionally between $3 \cdot 10^{-2}$ Ohm·m$^2$ and $1 \cdot 10^{-1}$ Ohm·m$^2$, optionally between $1 \cdot 10^{-1}$ Ohm·m$^2$ and $3 \cdot 10^{-1}$ Ohm·m$^2$.

Example 2. The superconductor cable (21) of example 1, further comprising: a layer of second metallic stabilizer material (26), wherein the layer of ohmic heating material (25) is arranged at least partially or entirely between the superconductor region and the layer of second metallic stabilizer material (26) and/or
wherein the surface resistivity of the ohmic heating material (25) is defined between the superconductor region and the layer of second metallic stabilizer material (26).

Example 3. The superconductor cable (21) of example 1 or example 2,

wherein the layer of ohmic heating material (25) entirely surrounds the superconductor region and/or

wherein the layer of ohmic heating material (25) is arranged in between the superconductor region and the second metallic stabilizer material (26);
and/or

wherein the layer of ohmic heating material (25) has a thickness between 0.01 mm to 10 mm.

Example 4. The superconductor cable (21) of any of examples 1 to 3,

wherein, when from a first position along the superconductor cable to a second position along the superconductor cable the high temperature superconductor material is in a non-superconducting state, the superconductor cable (21) has:

a first resistance, Rnz, determined for current passing through the superconductor region from the first position to the second position and
a second resistance, Rbypass, determined for current not passing through the superconductor region from the first position to the second position;

and wherein a ratio Rnz to Rbypass is at least 1.

Example 5. The superconductor cable (21) of any of examples 2 to 4, further comprising:
a layer of insulation material (27) at least partially surrounding the layer of second metallic stabilizer material (26), wherein the layer of insulation material (27) has a resistivity of at least $1 \cdot 10^4$ Ohm · m.

Example 6. The superconductor cable (21) of any of examples 1 to 5, wherein the superconductor cable (21) further comprises:

at least one second high temperature superconductor material, optionally at least one second stack of high temperature superconductor tapes (23b) and/or

at least one third high temperature superconductor material, optionally at least one third stack of high temperature superconductor tapes (23c); and/or

at least one fourth high temperature superconductor material, optionally at least one fourth stack of high temperature superconductor tapes (23d);
wherein, optionally, the high temperature superconductor material, the at least one second high temperature superconductor material, the at least one third high temperature superconductor material and/or the at least one fourth high temperature superconductor material are one or more of the following:

electrically insulated from each other,

electrically connected with each other,

connected by a third metallic stabilizer material (24c),

at least partially or entirely surrounded by the layer of ohmic heating material (25).

Example 7. The superconductor cable (21) of any of examples 1 to 6, wherein the high temperature superconductor material (23) and/or the at least one second high temperature superconductor material and/or the at least one third high temperature superconductor material and/or the at least one fourth high temperature superconductor material is twisted along a length of the superconductor cable (21).

Example 8. The superconductor cable (21) of any of examples 1 to 7, wherein the first metallic stabilizer material (24) further comprises a metallic jacket layer (24b).

Example 9. The superconductor cable (21) of any of examples 1 to 8, wherein along a length (LD) of the superconductor cable (21):

the resistivity of the ohmic heating material (25) changes and/or

a local thickness of the ohmic heating material (25) changes.

Example 10. The superconductor cable of example 9, wherein the local thickness and/or resistivity of the ohmic heating material (25) in a region at the start (R1) along the length of the superconductor cable (21) and/or in a region at the end (R2) along the length of the superconductor cable (21) are different from the local thickness and/or resistivity of the ohmic heating material in a region in the middle (P3) along the length of the superconductor cable.

Example 11. The superconductor cable (21) of any of examples 1 to 10, wherein

the first metallic stabilizer material (24) comprises at least one of the following materials: solder, copper, copper alloy, brass, aluminium, aluminium alloy and/or

the layer of ohmic heating material (25) comprises at least one of the following materials:silicon carbide, semi-metals, semiconductors, anodised aluminium, matrix composites and/or

the layer of second metallic stabilizer (26) material comprises at least one of the following materials: solder, copper, copper alloy, brass, aluminium or aluminium alloy, a high-strength material, steel; and/or

the optional layer of insulation material (27) comprises at least one of the following materials: organic insulators, polyimide, inorganic insulators, ceramic, nonconductive epoxy, a glass fibre matrix, insulation paper, insulating lacquer, paint.

Example 12. A superconductor cable assembly (22), preferably a superconductor magnetic field coil (20, 20a, 20b), comprising a plurality of turns (31, 32, 33) of a superconductor cable (21) and/or a plurality of superconductor cables (21, 41, 42) according to any of examples 1 to 11.

Example 13. A superconductor cable assembly (22) comprising at least one superconductor cable (21), the at least one superconductor cable (21) comprising:
a superconductor region, the superconductor region comprising:

high temperature superconductor material, optionally high temperature superconductor tapes (23) and

a first metallic stabilizer material (24); the superconductor cable further comprising:
a layer of ohmic heating material (25) at least partially surrounding the superconductor region;

the superconductor cable assembly (22) further comprising:

a layer of second metallic stabilizer material (26) at least partially or entirely surrounding the layer of ohmic heating material (25);

wherein a thickness and resistivity of the layer of ohmic heating material (25) are configured such that a first velocity (v1) of a non-superconducting zone propagation along the superconductor cable (21) is larger than a second velocity (v2) of non-superconducting zone propagation in a radial direction of the superconductor cable assembly (22).

Example 14. The superconductor cable assembly (22) of example 13, wherein the superconductor cable assembly (22) is a magnetic field coil (20, 20a, 20b) comprising a plurality of turns (31, 32, 33) of the at least one superconductor cable (21) and/or wherein the radial direction of the superconductor cable assembly (22) is a direction perpendicular to a local direction along at least one of the plurality of turns (31, 32, 33).

Example 15. The superconductor cable assembly (22) of example 14,
wherein a ratio of the first velocity (v1) to the second velocity (v2) is configured such that a locally formed non-superconducting zone (50) in one of the turns (31, 32, 33) of the plurality of turns propagates along a substantial distance of the turn before an adjacent turn becomes non-superconducting.

Example 16. The superconductor cable assembly (22) of any of examples 12 to 15, wherein the superconductor cable assembly (22) further comprises:
a layer of insulation material (27) surrounding the layer of second metallic stabilizer material (26), wherein the layer of insulation material (27) has a resistivity of at least $1 \cdot 10^4$ Ohm $\cdot$ m.

Example 17. The superconductor cable assembly (22) of any of examples 12 to 16, wherein the second metallic stabilizer (26) further comprises a conductive support structure (26a), wherein:

the superconductor cable is embedded in the conductive support structure (26a) and/or

the conductive support structure (26a) comprises at least one of the following materials: stainless steel, titanium, composite carbon fibre, inconel, nitronic alloy, high strength alloys.

Example 18. The superconductor cable assembly (22) of any of examples 12 to 17, wherein the superconductor cable assembly (22) is a planar magnetic field coil (20a) or a non-planar magnetic field coil (20b) for a stellarator (1).

Example 19. System (100) for preventing damage to at least one superconductor cable assembly (22) of any of examples 12 to 18, the system comprising:
at least one sensor (110) connected to the at least one superconductor cable assembly (22);

a power control unit (130) connected to the at least one superconductor cable assembly (22);
at least one non-superconducting zone generation means (140) connected to the at least one superconductor cable assembly (22);

optionally, a dump circuitry (150);and

a control unit (120), operably connected to the at least one sensor (110), the power control unit (130),the at least one non-superconducting zone generation means (140) and optionally connected to the dump circuitry (150), the control unit (120) configured to:

determine that a local non-superconducting zone (50) has developed in at least one of the at least one superconductor cable assembly (22) based on the at least one sensor (110);

optionally, interrupt a connection to a power control unit (130) of the at least one superconductor cable assembly (22);

optionally, activate the non-superconducting zone generation means (140) to generate at least one additional non-superconducting zone in the at least one superconductor cable assembly (22), and

optionally, connect a dump circuitry (150) to the at least one superconductor cable assembly (22).

Example 20. The system of example 19, wherein the non-superconducting zone generation means (140) is at least one of the following:

at least one heating element attached to the at least one superconductor cable assembly (22)

at least one alternating current generation means coupled to the at least one superconductor cable assembly (22),

and wherein the control unit (120) is further configured to:
activate the at least one heating element and/or the at least one alternating current generation means to generate the at least one additional non-superconducting zone.

Example 21. A method (1200) for preventing damage to at least one superconductor cable assembly (22), comprising the following steps:

determining (S1) that a local non-superconducting zone (50) has developed in the at least one superconductor cable assembly (22);

interrupting (S2) a connection of a power control unit (130) with the at least one superconductor cable assembly (22);

optionally, activating (S3) a non-superconducting zone generation means (140) to generate at least one additional non-superconducting zone;

optionally, connecting (S4) a dump circuitry (150) to the at least one superconductor cable assembly (22).

Example 22. The method of example 21, wherein the non-superconducting zone generation means (140) is at least one of the following:

at least one heating element (140) attached to the at least one superconductor cable assembly (22),

at least one alternating current generation means coupled to the at least one superconductor cable assembly (22).

Example 23. The method of example 21 or example 22, wherein the at least one superconductor cable assembly (22) comprises a plurality of superconductor cable assemblies and wherein the method further comprises:
in response to the determining that a local non-superconducting zone (50) has developed in the at least one superconductor cable assembly (22):
performing at least one of the steps of interrupting, activating and connecting for all of the plurality of superconductor cable assemblies.

Example 24. A superconductor cable (21) for a superconductor cable assembly (22), comprising:
a superconductor region, the superconductor region comprising:

high temperature superconductor material, optionally high temperature superconductor tapes (23) and

a first metallic stabilizer material (24); the superconductor cable further comprising:
a layer of ohmic heating material (25) at least partially surrounding the superconductor region.

Example 25. The superconductor cable (21) of example 24, wherein

the layer of ohmic heating material (25) has a surface resistivity between $10^{-7}$ Ohm·m$^2$ and 1 Ohm·m$^2$, optionally between $10^{-7}$ Ohm·m$^2$ and 1 Ohm·m$^2$, optionally between $10^{-6}$ Ohm·m$^2$ and $10^{-1}$ Ohm·m$^2$, optionally between $10^{-5}$ Ohm·m$^2$ and $10^{-2}$ Ohm·m$^2$, optionally between $10^{-4}$ Ohm·m$^2$ and $10^{-3}$ Ohm·m$^2$, optionally between $2 \cdot 10^{-4}$ Ohm·m$^2$ and $5 \cdot 10^{-4}$ Ohm·m$^2$, optionally of approximately $3 \cdot 10^{-4}$ Ohm.m$^2$; and/or
and/or

wherein the layer of ohmic heating material (25) has a surface resistivity between $10^{-7}$ Ohm.m$^2$ and $3 \cdot 10^{-4}$ Ohm m$^2$, optionally between $5 \cdot 10^{-7}$ Ohm·m$^2$ and $1.5 \cdot 10^{-4}$ Ohm·m$^2$, optionally between $1 \cdot 10^{-6}$ Ohm.m$^2$ and $7.5 \cdot 10^{-5}$ Ohm·m$^2$, optionally between $5 \cdot 10^{-6}$ Ohm·m$^2$ and $3 \cdot 10^{-5}$ Ohm·m$^2$, optionally between $10^{-5}$ Ohm·m$^2$ and $1.5 \cdot 10^{-5}$ Ohm·m$^2$, optionally between $3 \cdot 10^{-5}$ Ohm·m$^2$ and $1 \cdot 10^{-5}$ Ohm·m$^2$
and /or

wherein the layer of ohmic heating material (25) has a surface resistivity between $3 \cdot 10^{-4}$ Ohm.m$^2$ and 1 Ohm·m$^2$, optionally between $1 \cdot 10^{-3}$ Ohm.m$^2$ and $3 \cdot 10^{-1}$ Ohm·m$^2$, optionally between $3 \cdot 10^{-3}$ Ohm.m$^2$ and $1 \cdot 10^{-1}$ Ohm·m$^2$, optionally between $1 \cdot 10^{-2}$ Ohm·m$^2$ and $3 \cdot 10^{-2}$ Ohm·m$^2$, optionally between $3 \cdot 10^{-2}$ Ohm·m$^2$ and $1 \cdot 10^{-1}$ Ohm·m$^2$, optionally between $1 \cdot 10^{-1}$ Ohm·m$^2$ and $3 \cdot 10^{-1}$ Ohm·m$^2$.

Example 26. The superconductor cable (21) of example 24 or 25, wherein the superconductor cable (21) further comprises features according to at least one of examples 2 to 11.

In this specification, example embodiments have been presented in terms of a selected set of details. However, a skilled person of ordinary skill in the art would understand that many other example embodiments may be practiced which include a different selected set of these details. It is intended that the following claims cover all possible example embodiments.

**Reference List (part of description):**

| | |
|---|---|
| 1 | Stellarator |
| 19 | superconductor region |
| 21 | superconductor cable |
| 22 | superconductor cable assembly |
| 23 | stack of high temperature superconductor tapes |
| 23b | second stack of high temperature superconductor tapes |
| 23c | third stack of high temperature superconductor tapes |
| 23d | fourth stack of high temperature superconductor tapes |
| 24 | first metallic stabilizer material |
| 25 | layer of ohmic heating material |
| 26 | layer of second metallic stabilizer material |
| 26a | conductive support structure |
| 26b | further layer of metallic stabilizer material |
| 27 | layer of insulation material |
| 24c | third metallic stabilizer material |
| 20 | superconductor magnetic field coil |
| 20a | planar magnetic field coil |
| 20b | non-planar magnetic field coil |
| 31-33 | turns |
| 50, 50a, 50b | non-superconducting zone |
| 100 | system |
| 110 | sensor |
| 120 | control unit |
| 130 | power control unit |
| 140 | non-superconducting zone generation means |
| 150 | dump circuitry |

A superconductor cable 21 for a superconductor cable assembly 22, comprising:
a superconductor region 19, the superconductor region 19 comprising:

high temperature superconductor material, optionally high temperature superconductor tapes 23, and

a first metallic stabilizer material 24;

a layer of ohmic heating material 25 at least partially surrounding the superconductor region 19;

The layer of ohmic heating material 25 may have a surface resistivity between $10^{-7}$ Ohm·m$^2$ and 1 Ohm·m$^2$.

## Claims

**1.** A superconductor cable (21) for a superconductor cable assembly (22), comprising:
a superconductor region (19), the superconductor region (19) comprising:

high temperature superconductor material, optionally, high temperature superconductor tapes (23), and
a first metallic stabilizer material (24);
the superconductor cable further comprising:
a layer of ohmic heating material (25) at least partially surrounding the superconductor region (19);
wherein the layer of ohmic heating material (25) has a surface resistivity between $10^7$ Ohm·m$^2$ and 1 Ohm·m$^2$.

**2.** The superconductor cable (21) of claim 1, further comprising: a layer of second metallic stabilizer material (26), wherein the layer of ohmic heating material (25) is arranged at least partially or entirely between the superconductor region (19) and the layer of second metallic stabilizer material (26) and/or
wherein the surface resistivity of the ohmic heating material (25) is defined between the superconductor region (19) and the layer of second metallic stabilizer material (26).

**3.** The superconductor cable (21) of claim 1 or claim 2,

wherein the layer of ohmic heating material (25) entirely surrounds the superconductor region (19) and/or
the superconductor cable (21) of claim 2, wherein the layer of ohmic heating material (25) is arranged in between the superconductor region (19) and the second metallic stabilizer material (26);
and/or
wherein the layer of ohmic heating material (25) has a thickness between 0.01 mm to 10 mm.

**4.** The superconductor cable (21) of any of claims 1 to 3,

wherein, when from a first position along the superconductor cable to a second position along the superconductor cable the high temperature superconductor material is in a non-superconducting state, the superconductor cable (21) has:
a first resistance, Rnz, determined for current passing through the superconductor region (19) from the first position to the second position and a second resistance, Rbypass, determined for current not passing through the superconductor region (19) from the first position to the second position;

and wherein a ratio Rnz to Rbypass is at least 1.

**5.** The superconductor cable (21) of any of claims 2 to 4, further comprising:
a layer of insulation material (27) at least partially surrounding the layer of second metallic stabilizer material (26), wherein the layer of insulation material (27) has a resistivity of at least $10^4$ Ohm · m.

**6.** The superconductor cable (21) of any of claims 1 to 5, wherein the superconductor cable (21), optionally, the superconductor region (19), further comprises:

at least one second high temperature superconductor material, optionally, at least one second stack of high temperature superconductor tapes (23b) and/or
at least one third high temperature superconductor material, optionally, at least one third stack of high temperature superconductor tapes (23c); and/or
at least one fourth high temperature superconductor material, optionally, at least one fourth stack of high temperature superconductor tapes (23d);
wherein, optionally, the high temperature superconductor material, the at least one second high temperature superconductor material, the at least one third high temperature superconductor material and/or the at least one fourth high temperature superconductor material are one or more of the following:

electrically insulated from each other,
electrically connected with each other,
connected by a third metallic stabilizer material (24c),
at least partially or entirely surrounded by the layer of ohmic heating material (25);

and/or
wherein the high temperature superconductor material (23) and/or the at least one second high temperature superconductor material and/or the at least one third high temperature superconductor material and/or the at least one fourth high temperature superconductor material is twisted along a length of the superconductor cable (21).

**7.** The superconductor cable (21) of any of claims 1 to 6, wherein along a length (LD) of the superconductor cable (21):

the resistivity of the ohmic heating material (25) changes and/or
a local thickness of the ohmic heating material (25) changes;
and/or
wherein the local thickness and/or resistivity of the ohmic heating material (25) in a region at the start (R1) along the length of the superconductor cable (21) and/or in a region at the end (R2) along the length of the superconductor cable (21) are different from the local thickness and/or resistivity of the ohmic heating material in a region in the middle (R3) along the length of the superconductor cable.

**8.** The superconductor cable (21) of any of claims 1 to 7, wherein

the first metallic stabilizer material (24) comprises at least one of the following materials: solder, copper, copper alloy, brass, aluminium, aluminium alloy and/or
the layer of ohmic heating material (25) comprises at least one of the following materials: silicon carbide, semi-metals, semiconductors, anodised aluminium, matrix composites and/or
the layer of second metallic stabilizer (26) material comprises at least one of the following materials: solder, copper, copper alloy, brass, aluminium or aluminium alloy, a high-strength material, steel; and/or
the optional layer of insulation material (27) comprises at least one of the following materials: organic insulators, polyimide, inorganic insulators, ceramic, nonconductive epoxy, a glass fibre matrix, insulation paper, insulating lacquer, paint.

**9.** A superconductor cable assembly (22), preferably a superconductor magnetic field coil (20, 20a, 20b), comprising a plurality of turns (31, 32, 33) of a superconductor cable (21) and/or a plurality of superconductor cables (21, 41, 42) according to any of claims 1 to 8.

**10.** A superconductor cable assembly (22) comprising at least one superconductor cable (21), the at least one superconductor cable (21) comprising:
a superconductor region (19), the superconductor region (19) comprising:

high temperature superconductor material, optionally, high temperature superconductor tapes (23) and

a first metallic stabilizer material (24); the superconductor cable further comprising:
a layer of ohmic heating material (25) at least partially surrounding the superconductor region (19);

the superconductor cable assembly (22) further comprising:

a layer of second metallic stabilizer material (26) at least partially or entirely surrounding the layer of ohmic heating material (25);
wherein a thickness and resistivity of the layer of ohmic heating material (25) are configured such that a first velocity (v1) of a non-superconducting zone propagation along the superconductor cable (21) is larger than a second velocity (v2) of non-superconducting zone propagation in a radial direction of the superconductor cable assembly (22).

**11.** The superconductor cable assembly (22) of claim 10, wherein the superconductor cable assembly (22) is a superconductor magnetic field coil (20, 20a, 20b), preferably a planar magnetic field coil (20a) or a non-planar magnetic field coil (20b) for a stellarator (1), the superconductor cable assembly (22) comprising: a plurality of turns (31, 32, 33) of the at least one superconductor cable (21) and/or wherein the radial direction of the superconductor cable assembly (22) is a direction perpendicular to a local direction along at least one of the plurality of turns (31, 32, 33).

**12.** The superconductor cable assembly (22) of claim 11, wherein a ratio of the first velocity (v1) to the second velocity (v2) is configured such that a locally formed non-superconducting zone (50) in one of the turns (31, 32, 33) of the plurality of turns propagates along a substantial distance of the turn before an adjacent turn becomes non-superconducting.

**13.** The superconductor cable assembly (22) of any of claims 9 to 12, wherein the superconductor cable assembly (22) further comprises:
a layer of insulation material (27) surrounding the layer of second metallic stabilizer material (26), wherein the layer of insulation material (27) has a resistivity of at least $1 \cdot 10^4$ Ohm · m.

**14.** The superconductor cable assembly (22) of any of claims 9 to 13, wherein the second metallic stabilizer (26) further comprises a conductive support structure (26a), wherein:

the superconductor cable is embedded in the conductive support structure (26a) and/or
the conductive support structure (26a) comprises at least one of the following materials: stainless steel, titanium, composite carbon fibre, inconel, nitronic alloy, high strength alloys.

**15.** System (100) for preventing damage to at least one superconductor cable assembly (22) of any of claims 9 to 14, the system comprising:
at least one sensor (110) connected to the at least one superconductor cable assembly (22);

a power control unit (130) connected to the at least one superconductor cable assembly (22);
at least one non-superconducting zone generation means (140) connected to the at least one superconductor cable assembly (22);
optionally, a dump circuitry (150); and
a control unit (120), operably connected to the at least one sensor (110), the power control unit (130), the at least one non-superconducting zone generation means and, optionally, connected to the dump circuitry (150), the control unit (120) configured to:

determine that a local non-superconducting zone (50) has developed in at least one of the at least one superconductor cable assembly (22) based on the at least one sensor (110);
optionally, interrupt a connection to a power control unit (130) of the at least one superconductor cable assembly (22);
optionally, activate the non-superconducting zone generation means (140) to generate at least one additional non-superconducting zone in the at least one superconductor cable assembly (22), and
optionally, connect a dump circuitry (150) to the at least one superconductor cable assembly (22) and, optionally, wherein the non-superconducting zone generation means (140) is at least one of the following:

at least one heating element attached to the at least one superconductor cable assembly (22)
at least one alternating current generation means coupled to the at least one superconductor cable assembly (22),

and wherein the control unit (120) is further configured to:
activate the at least one heating element and/or the at least one alternating current generation means to generate the at least one additional non-superconducting zone.

1
20
10
20
20
20
P
20b
20a
20

Fig. 1

21
23
24
25
19

Fig. 2a

21
23
24
25

RD
LD

Fig. 2b

21
23
24
25
26

Fig. 3a

21
23
24
25
26
RD
LD

Fig. 3b

23
21
24
60
60
25
26
$I_o$
60
50
60
$I_1$
RD
LD

Fig. 3c

21
23
24,24a
25
26
27
24,24b

Fig. 4

21
24
24c
25
26
27
23b
23c

Fig. 5a

21
26a
27
23d
23
26
25
23c
23b

Fig. 5b

21
26a
23d
25
23
26
23c
23b

Fig. 5c

21
26a
23d
25
23
26
23c
23b

Fig. 5d

R1
R3
R2
21
23
24
25
RD
LD

Fig. 6

20,22
23
24
25
21
23
24
25
23
24
25
31
32
26a
RD
33

Fig. 7a

20,22
23
24
25
21
31
32
33
26a
RD
LD

Fig. 7b

22
23
24
25
23
24
25
23
24
25
41
21
26a
RD
42

Fig. 7c

41
20,22
23
24
25
21
42
26a
RD
LD

Fig. 7d

21
26a
23
23b
19
23c
27
24
25
26

Fig. 7e

22
31
V2
V1
32
50a
50b
33
RD
LD

Fig. 8

21
31
32
33
26,26a
22,20b
24
23
25

Fig. 9

22,20a
I
21
26a
I
50
$I_t$

Fig. 10

50
31
22
25
32
23
$I_t$
60
33
TL
TL
RD
LD

Fig. 11a

21
24
25
23
26b
27
26
21
50
26b
26
25
24
$w_{tape}$
$d_{stab}$
$d_{stack}$
$l_{NZ}$
$l_{CTL}$~5*λ
$l_{CTL}$~5*λ
23

Fig. 11b

110
120
$I_{stab}$
100
I
$e^{-1}$• I
130
0
0
λ
x

Fig. 11c

100
152
153
150
130
151
131
120
140
110
20

Fig. 12

1200
S1
DETERMINING A LOCAL NON-SUPERCONDUCTING ZONE HAS DEVELOPED IN A SUPERCONDUCTING CABLE ASSEMBLY
S2
INTERRUPTING A CONNECTION TO A POWER CONTROL UNIT OF THE SUPERCONDUCTING CABLE ASSEMBLY
S3
(OPTIONAL) ACTIVATION A NON-SUPERCONDUCTING ZONE GENERATION MEANS TO GENERATE AN ADDITIONAL NON-SUPERCONDUCTING ZONE
S4
(OPTIONAL) CONNECTING A DUMP CIRCUITRY TO THE SUPERCONDUCTING CABLE ASSEMBLY

Fig. 13

# EUROPEAN SEARCH REPORT

Application Number
EP 24 21 3309

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/395296 A1 (SLADE ROBERT [GB] ET AL) 7 December 2023 (2023-12-07) | 1-4,6-9 | INV. H10N60/20 H01F6/06 |
| Y | * figures 1-4 * | 5,13,14 | |
| A | * paragraph [0007] - paragraph [0010] * * paragraph [0023] * * paragraph [0084] * * paragraph [0110] - paragraph [0136] * ----- | 10-12,15 | ADD. G21B1/05 |
| X | US 2019/074118 A1 (KIM SEOG WHAN [KR] ET AL) 7 March 2019 (2019-03-07) | 1-4,6-9 | |
| Y | * figures 1, 2, 6-8, 10; table 1 * | 5,13,14 | |
| A | * paragraph [0007] - paragraph [0012] * * paragraph [0029] * * paragraph [0055] - paragraph [0060] * * paragraph [0076] - paragraph [0083] * ----- | 10-12,15 | |
| Y | SUETOMI Y ET AL: "Quench and self-protecting behaviour of an intra-layer no-insulation (LNI) REBCO coil at 31.4 T", SUPERCONDUCTOR SCIENCE AND TECHNOLOGY., vol. 34, no. 6, 1 June 2021 (2021-06-01), page 064003, XP093242141, GB ISSN: 0953-2048, DOI: 10.1088/1361-6668/abf54e | 5,13 | TECHNICAL FIELDS SEARCHED (IPC) |
| | | | H10N H01F G21B |
| A | * figures 1, 22 * ----- | 10-12,15 | |
| Y | US 2008/242551 A1 (PAINTER THOMAS A [US]) 2 October 2008 (2008-10-02) | 14 | |
| A | * paragraph [0033]; figure 2 * ----- | 10-12,15 | |
| A | CN 117 578 352 A (INST MODERN PHYSICS CAS) 20 February 2024 (2024-02-20) * paragraph [0031] - paragraph [0037]; figure 1 * ----- | 15 | |

The present search report has been drawn up for all claims

3

| Place of search | Date of completion of the search | Examiner |
|---|---|---|
| Munich | 2 April 2025 | Krohns, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 21 3309

This annex lists the patent family members relating to the patent documents cited in the above-mentioned European search report. The members are as contained in the European Patent Office EDP file on
The European Patent Office is in no way liable for these particulars which are merely given for the purpose of information.

02-04-2025

| Patent document cited in search report | Publication date | Patent family member(s) | Publication date |
|---|---|---|---|
| US 2023395296 A1 | 07-12-2023 | EP 4233081 A2 | 30-08-2023 |
| | | GB 2600110 A | 27-04-2022 |
| | | JP 7642806 B2 | 10-03-2025 |
| | | JP 2024503776 A | 29-01-2024 |
| | | US 2023395296 A1 | 07-12-2023 |
| | | WO 2022084398 A2 | 28-04-2022 |
| US 2019074118 A1 | 07-03-2019 | CN 107949890 A | 20-04-2018 |
| | | EP 3346475 A1 | 11-07-2018 |
| | | JP 2018532262 A | 01-11-2018 |
| | | KR 20170028837 A | 14-03-2017 |
| | | US 2019074118 A1 | 07-03-2019 |
| | | WO 2017039299 A1 | 09-03-2017 |
| US 2008242551 A1 | 02-10-2008 | NONE | |
| CN 117578352 A | 20-02-2024 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *Van der Pauw method*, 14 November 2024, https://en.wikipedia.org/w/index.php?title=Van_-der_Pauw_method&oldid=1236164 392
- **OLIVEIRA FS** ; **CIPRIANO RB** ; **DA SILVA FT** ; **ROMÃO EC** ; **DOS SANTOS CAM**. Simple analytical method for determining electrical resistivity and sheet resistance using the van der Pauw procedure. *Sci Rep.*, 02 October 2020, vol. 10 (1), 16379